# EUROPEAN PATENT SPECIFICATION

(11) **EP 4 398 252 B1**
(45) Date of publication and mention of the grant of the patent: **29.07.2026**
(21) Application number: 23169273.2
(22) Date of filing: 21.04.2023
(51) Int. Cl.: G11C 16/10, G11C 16/26

(54) **MANAGING PAGE BUFFER CIRCUITS IN MEMORY DEVICES**
VERWALTUNG VON SEITENPUFFERSCHALTUNGEN IN SPEICHERVORRICHTUNGEN
GESTION DE CIRCUITS DE TAMPON DE PAGE DANS DES DISPOSITIFS DE MÉMOIRE

(30) Priority: 05.01.2023 US 202318150584; 05.01.2023 US 202318150594
(43) Date of publication of application: 10.07.2024
(73) Proprietor: MACRONIX INTERNATIONAL CO., LTD., Hsinchu 300094 (TW)
(72) Inventor: HUNG, Ji-Yu, 350 Jhunan Township, Miaoli County (TW); CHANG, E-Yuan, 600 Chiayi City (TW)
(74) Representative: Krauns, Christian

(56) References cited:
- EP-A1- 3 955 254
- US-A1- 2022 020 404
- US-A1- 2022 366 964
- US-A1- 2022 406 342

## Description

### BACKGROUND

Integrated circuit memory devices are becoming smaller and faster. One limitation on a size of a memory device arises from a size of an actual sensing capacitor in a page buffer circuit. To sense data stored in the memory device, the actual sensing capacitor needs to have a large capacitance, which normally requires a large area. Therefore, it would be desirable to develop a page buffer circuit that can provide a large and stable capacitance without the actual sensing capacitor.

The US 2022/0366964 A1 discloses a page buffer circuit including a plurality of page buffers connected to a plurality of bitlines. Each of the plurality of page buffers includes a bitline selection transistor configured to connect a corresponding bitline of the plurality of bitlines to a sensing node, a precharge circuit configured to precharge the sensing node, and a dynamic latch circuit configured to store data in a storage node. Each of the plurality of page buffers is configured to refresh the data stored in the storage node through charge sharing between the storage node and the sensing node.

The EP 3,955,254 A1 discloses a nonvolatile memory device including a memory cell array including memory cells and a page buffer circuit. The page buffer circuit includes page buffer units and cache latches. The cache latches are spaced apart from the page buffer units in a first horizontal direction, and correspond to respective ones of the plurality of page buffer units. Each of the page buffer units includes a pass transistor connected to each sensing node and driven in response to a pass control signal. The page buffer circuit is configured to perform a data transfer operation, based on performing a first data output operation to output data, provided from a first portion of page buffer units, from a first portion of cache latches to a data input/output line, the data transfer operation configured to dump sensed data from a second portion of page buffer units to a second portion of cache latches.

The US 2022/020404 A1 discloses a page buffer and a memory device including the same. The memory device includes a memory cell array including a plurality of memory cells; and a page buffer circuit including page buffer units in a first horizontal direction, the page buffer units being connected to the memory cells via bit lines, and cache latches in the first horizontal direction, the cache latches corresponding to the page buffer units, wherein each of the page buffer units includes one or more pass transistors connected to a sensing node of each of the plurality of page buffer units, the sensing node electrically connected to a corresponding bit line. Each sensing node included in each of the page buffer units and the combined sensing node are electrically connected to each other through the pass transistors.

### SUMMARY

The problem of the present invention is solved by a page buffer circuit according to the independent claim 1. The dependent claims refer to further advantageous developments of the present invention.

The present disclosure describes methods, systems, devices, circuits, and techniques for managing page buffer circuits in memory devices, for example, by providing page buffers that use existed metal routing (e.g., global data bus (DBUS) metal lines) to form parasitic capacitors, without using any actual capacitors or any extra metal routing.

One aspect of the present disclosure features a memory device, including: a memory cell array including memory cells; a page buffer circuit including a plurality of page buffers coupled to the memory cell array; and a cache data latch (CDL) circuit including a plurality of caches coupled to the plurality of page buffers in the page buffer circuit through a plurality of data bus (DBUS) sections. The plurality of DBUS sections is configured to be conductively connected together as a data bus for data transfer. Each DBUS section of the plurality of DBUS sections corresponds to a page buffer of the plurality of page buffers and is configured to conductively separate from at least one adjacent DBUS section for data sensing in the memory cell array. Each DBUS section can be configured to form a parasitic capacitor with at least one inner conductive line in the page buffer for the data sensing.

In some embodiments, the memory device further includes a plurality of bit lines coupled between the memory cell array and the page buffer circuit. Each page buffer of the plurality of page buffers is conductively coupled to a corresponding memory cell in the memory cell array through a bit line of the plurality of bit lines.

In some embodiments, the memory device includes a plurality of connection transistors coupled between adjacent DBUS sections in the plurality of DBUS sections. The plurality of connection transistors is configured to: be turned on to conductively connect the plurality of DBUS sections together to form the data bus, and be turned off to conductively separate the plurality of DBUS sections from each other. Each DBUS section can function as a sensing node in the page buffer to form the parasitic capacitor with the at least one inner conductive line in the page buffer.

In some embodiments, each connection transistor of the plurality of connection transistors is coupled between two adjacent DBUS sections and arranged between adjacent page buffers corresponding to the two adjacent DBUS sections.

In some embodiments, each page buffer of the plurality of page buffers includes: a first transistor configured to be a connection transistor corresponding to the page buffer among the plurality of connection transistors, and a DBUS section of the plurality of DBUS sections. The first transistor has a first terminal coupled to the DBUS section of the page buffer, a second terminal coupled to an adjacent DBUS section of an adjacent page buffer, and a gate terminal configured to receive a control signal for turning on or off the first transistor.

In some embodiments, each page buffer of the plurality of page buffers further includes a second transistor having: a first terminal coupled to one or more latches in the page buffer through the at least one inner conductive line, a second terminal coupled to the DBUS section, and a gate terminal coupled to receive a second control signal for turning on or off the second transistor. The memory device can be configured to: turn on the plurality of connection transistors to conductively connect the plurality of DBUS sections to form the data bus, and turn on a respective second transistor of a particular page buffer of the plurality of page buffers and turn off second transistors in other page buffers of the plurality of page buffers, such that data latched in the particular page buffer is transferred from the particular page buffer to a corresponding cache in the CDL circuit through the data bus.

In some embodiments, the second transistor is configured to be turned on to couple the DBUS section to a supply voltage for precharging the parasitic capacitor of the page buffer while the plurality of connection transistors are turned off to conductively separate the plurality of DBUS sections.

In some embodiments, each page buffer of the plurality of page buffers includes: a DBUS section having a first sub-section and a second sub-section, a section transistor coupled between the first sub-section and the second sub-section. The section transistor can be configured to: be turned on to conductively connect the first sub-section and the second sub-section to form the DBUS section such that the plurality of DBUS sections are configured to be conductively connected together as the data bus, and be turned off to conductively separate the first sub-section and the second sub-section such that the first sub-section forms the parasitic capacitor with a corresponding inner conductive line in the page buffer.

In some embodiments, the first sub-section is a non-coupling-noise sub-section, and the second sub-section is coupling-noise sub-section.

In some embodiments, the first sub-section of the DBUS section is positioned adjacent to an inner data line (IDL) in the page buffer, and the second sub-section of the DBUS section is positioned adjacent to a bit line through which the page buffer is coupled to the memory cell array.

In some embodiments, the plurality of page buffers includes first and second page buffers sequentially arranged in the page buffer circuit, and a second sub-section of the first page buffer is coupled to a first sub-section of the second page buffer by a corresponding connection transistor of the plurality of connection transistors.

In some embodiments, the plurality of page buffers includes first, second, and third page buffers arranged in order in the page buffer circuit, and second sub-sections of the first and second page buffers are conductively connected, and first sub-sections of the second and third page buffers are coupled through a corresponding connection transistor of the plurality of connection transistors. In some embodiments, each of the first and third page buffers includes no connection transistor, and the second page buffer includes the corresponding connection transistor.

In some embodiments, the plurality of page buffers includes multiple pairs of first and second page buffers arranged in order in the page buffer circuit, and second sub-sections of the first and second page buffers are conductively connected, and first sub-sections of the first and second page buffers are respectively coupled to first sub-sections of adjacent page buffers in adjacent pairs through corresponding connection transistors of the plurality of connection transistors.

In some embodiments, each page buffer in the page buffer circuit includes a plurality of latches each conductively coupled to an inner data line (IDL) in the page buffer, and the IDL in the page buffer is configured to form the parasitic capacitor with a corresponding DBUS section for the page buffer.

In some embodiments, the IDL is positioned adjacent to and parallel to the corresponding DBUS section and conductively separated by an insulating material. In some embodiments, inner conductive lines in the plurality of page buffers and the plurality of DBUS sections are formed in a layer adjacent to the memory cell array.

In some embodiments, each page buffer in the page buffer circuit includes: a sensing latch coupled to the memory cell array, and a latch transistor coupled between the sensing latch and the IDL and configured to be turned on to conductively connect the sensing latch to the IDL or be turned off to separate the sensing latch from the IDL.

In some embodiments, each page buffer in the page buffer circuit includes a boosting transistor having: a first terminal coupled to the IDL, a second terminal configured to receive a boosting signal, and a gate terminal configured to receive a control signal to turn on or off the boosting transistor, and the boosting transistor can be configured to be turned on such that a voltage level of the IDL is controlled based on a voltage level of the boosting signal.

Another aspect of the present disclosure features a page buffer circuit including: a plurality of page buffers and a plurality of data bus (DBUS) sections. The plurality of DBUS sections are configured to be conductively connected together as a data bus, and each DBUS section in the plurality of DBUS sections corresponds to a page buffer of the plurality of page buffers, and is configured to conductively separate from at least one adjacent DBUS section for example, to form a parasitic capacitor with at least one inner conductive line in the page buffer.

In some embodiments, the page buffer circuit includes a plurality of connection transistors coupled between adjacent DBUS sections in the plurality of DBUS sections. The plurality of connection transistors are configured to: be turned on to conductively connect the plurality of DBUS sections together to form the data bus, and be turned off to conductively separate the plurality of DBUS sections from each other.

In some embodiments, each page buffer of the plurality of page buffers includes: a DBUS section of the plurality of DBUS sections, a first transistor configured to be a connection transistor corresponding to the page buffer among the plurality of connection transistors, and a second transistor having: a first terminal coupled to one or more latches in the page buffer through the at least one inner conductive line, a second terminal coupled to the DBUS section, and a gate terminal coupled to receive a second control signal for turning on or off the second transistor. The plurality of connection transistors can be configured to be turned on to conductively connect the plurality of DBUS sections to form the data bus, and a particular second transistor of a particular page buffer in the plurality of page buffers is configured to be turned on and second transistors of other page buffers of the plurality of page buffers are configured to be turned off, such that data latched in the particular page buffer is transferred from the particular page buffer to a corresponding cache in a cache data latch (CDL) circuit through the data bus.

In some embodiments, each page buffer of the plurality of page buffers includes: a DBUS section having a first sub-section and a second sub-section, and a section transistor coupled between the first sub-section and the second sub-section. The section transistor can be configured to: be turned on to conductively connect the first sub-section and the second sub-section to form the DBUS section such that the plurality of DBUS sections are configured to be conductively connected together as the data bus, and be turned off to conductively separate the first sub-section and the second sub-section such that the first sub-section forms the parasitic capacitor with a corresponding inner conductive line in the page buffer.

In some embodiments, the plurality of page buffers include first and second page buffers sequentially arranged in the plurality of page buffers, and a second sub-section of the first page buffer is coupled to a first sub-section of the second page buffer by a corresponding connection transistor of the plurality of connection transistors.

In some embodiments, the plurality of page buffers include first, second, and third page buffers arranged in order in the plurality of page buffers. Second sub-sections of the first and second page buffers can be conductively connected, and first sub-sections of the second and third page buffers are coupled through a corresponding connection transistor of the plurality of connection transistors. Each of the first and third page buffers can include no connection transistor, and the second page buffer can include the corresponding connection transistor.

In some embodiments, each page buffer of the plurality of page buffers includes: a plurality of latches each conductively coupled to an inner data line (IDL) in the page buffer, a sensing latch, and a latch transistor coupled between the sensing latch and the IDL and configured to be turned on to conductively connect the sensing latch to the IDL or be turned off to separate the sensing latch from the IDL. The IDL in the page buffer can be configured to form the parasitic capacitor with a corresponding DBUS section for the page buffer.

In some embodiments, each page buffer of the plurality of page buffers includes a boosting transistor having: a first terminal coupled to the IDL, a second terminal configured to receive a boosting signal, and a gate terminal configured to receive a control signal to turn on or off the boosting transistor, and the boosting transistor can be configured to be turned on such that a voltage level of the IDL is associated with a voltage level of the boosting signal.

Another aspect of the present disclosure features an integrated circuit including: a first circuit including a plurality of sub-circuits and a second circuit coupled to the first circuit through a plurality of conductive sections. The plurality of conductive sections are configured to be conductively connected together as a conductive bus between the first circuit and the second circuit, and each conductive section in the plurality of conductive sections corresponds to a sub-circuit in the first circuit, and is configured to conductively separate from at least one adjacent conductive section, for example, to form a parasitic capacitor with at least one inner conductive line in the sub-circuit.

In some embodiments, the first circuit includes a page buffer circuit including a plurality of page buffers, and the second circuit includes a cache data latch (CDL) circuit including a plurality of caches, and the integrated circuit can be configured to transfer data from a page buffer in the page buffer circuit to a corresponding cache in the CDL circuit through the conductive bus.

Another aspect of the present disclosure features a method including: conductively separating a plurality of data bus sections that are coupled between page buffers in a page buffer circuit and caches in a cache data latch (CDL) circuit, such that each data bus section forms a parasitic capacitor with at least one inner conductive line in a corresponding page buffer; and conductively connecting the plurality of data bus sections together to form a data bus for transferring data from one or more page buffers in the page buffer circuit to one or more corresponding caches in the CDL circuit.

In some embodiments, the method further includes: for a page buffer in the page buffer circuit, precharging a corresponding parasitic capacitor formed by a corresponding data bus section and a corresponding inner conductive line in the page buffer; discharging a sensing voltage at the corresponding data bus section by conductively connecting the corresponding data bus section to a memory cell through a corresponding bit line; and strobing a sensing result corresponding to data in the memory cell to a latch of the page buffer.

In some embodiments, the method further includes: after precharging the corresponding parasitic capacitor and before discharging the sensing voltage at the corresponding data bus section, boosting up a voltage level at the corresponding data bus section by increasing a voltage level at the corresponding inner conductive line; and after discharging the sensing voltage at the corresponding data bus section and before strobing the sensing result, boosting down the discharged sensing voltage at the corresponding data bus section by decreasing the voltage level at the corresponding inner conductive line.

In some embodiments, the page buffer includes a particular transistor coupled between the corresponding inner conductive line and the corresponding data bus section. The method can further include: turning on the particular transistor in the page buffer and turning off particular transistors in other page buffers in the page buffer circuit to transfer data latched in the page buffer to a corresponding cache in the CDL circuit through the data bus.

In some embodiments, the method includes: sequentially turning on a corresponding particular transistor in each of the page buffers in the page buffer circuit to transfer data latched in the page buffer to a corresponding cache in the CDL circuit through the data bus.

In some embodiments, the method includes: in response to receiving a read command for reading data from a memory cell array coupled to the page buffer circuit, conductively separating the plurality of data bus sections such that each data bus section forms the parasitic capacitor with at least one inner conductive line in the corresponding page buffer for sensing the data in the memory cell array.

In some embodiments, the method includes: in response to receiving a data transfer command for transferring the data from the one or more page buffers in the page buffer circuit to the one or more corresponding caches in the CDL circuit, conductively connecting the plurality of data bus sections together to form the data bus.

Implementations of the above techniques include methods, systems, circuits, computer program products and computer-readable media. In one example, a method can be performed in a non-volatile memory and the method can include the above-described actions, e.g., the actions for managing page buffer circuits. In another example, one such computer program product is suitably embodied in a non-transitory machine-readable medium that stores instructions executable by one or more processors. The instructions are configured to cause the one or more processors to perform the above-described actions. One such computer-readable medium stores instructions that, when executed by one or more processors, are configured to cause the one or more processors to perform the above-described actions.

The techniques can be implemented in any type of circuits or devices that need capacitors for implementing one or more functions. The techniques can replace actual capacitors with parasitic capacitors formed between conductive lines. For example, in a memory device such as NAND flash memory, a page buffer implemented according to the techniques can implement functions of a traditional metal-oxide-semiconductor (MOS) capacitor: a sensing accuracy and execution of voltage boosting of a sensing node, without using the MOS capacitor that can occupy a large page buffer area (e.g., about 20%). Also, compared to using inner metal lines inside a page buffer to get a limited parasitic sensing capacitance, the page buffer implemented herein uses a long outer (or global) data bus metal line (e.g., DBUS) and an inner data metal line (e.g., IDL) to achieve a larger sensing capacitance, which can avoid to be limited by a poor metal routing resource in the page buffer. The techniques also enable to reduce a device area (e.g., a size of a page buffer circuit and/or a memory device), minimize capacitor variation (e.g., caused by gate capacitors), reduce power consumption (e.g., due to large-area capacitors), and improve device performance (e.g., a sensing accuracy) with large capacitance.

The techniques can be implemented with any types of memory transistors (or memory cells), any types of metal-oxide-silicon (MOS) transistors, e.g., n-channel and/or p-channel transistors, any types of bipolar junction transistors (BJTs), and any types of operational amplifiers. The techniques can be applied to different types of memory systems, e.g., two-dimensional (2D) memory systems or three-dimensional (3D) memory systems. The techniques can be applied to various memory cell types, such as SLC (single-level cell), or MLC (multi-level cell) like 2-level cell, TLC (triple-level cell), TLC (quad-level cell), or PLC (Penta-level cell). The techniques can be applied to various types of volatile memory devices or non-volatile memory devices, such as Static Random Access Memory (SRAM), Dynamic Random Access Memory (DRAM), flash memory such as NOR flash memory and/or NAND flash memory, resistive random-access memory (RRAM), magnetoresistive random-access memory (MRAM), phase-change random-access memory (PCRAM), among others. Additionally or alternatively, the techniques can be applied to various types of devices and systems, such as secure digital (SD) cards, embedded multimedia cards (eMMC), or solid-state drives (SSDs), embedded systems, among others.

The details of one or more disclosed implementations are set forth in the accompanying drawings and the description below. Other features, aspects, and advantages will become apparent from the description, the drawings and the claims.

### BRIEF DESCRIPTION OF THE DRAWINGS

FIG. 1A illustrates an example system including a memory device.
FIG. 1B illustrates an example block of a two-dimensional (2D) memory device.
FIG. 1C illustrates an example block of a three-dimensional (3D) memory device.
FIG. 2A illustrates an example memory device including a page buffer circuit.
FIG. 2B illustrates an example page buffer circuit connected to a cache data latch (CDL) circuit with bus lines.
FIG. 3A illustrates an example integrated circuit including a page buffer circuit and a CDL circuit connected with a series of data bus sections.
FIG. 3B illustrates an example of a parasitic capacitor formed in the page buffer circuit of FIG. 3A.
FIG. 3C illustrates an example normal operation mode of the integrated circuit of FIG. 3A.
FIG. 3D illustrates an example data transfer mode of the integrated circuit of FIG. 3A.
FIG. 4A illustrates an example page buffer circuit with a sequence page buffer placement.
FIG. 4B illustrates an example page buffer circuit with a mirror page buffer placement.
FIG. 5A shows a circuit diagram illustrating an example page buffer in a page buffer circuit.
FIG. 5B shows a circuit diagram illustrating an example latch in a page buffer.
FIGS. 6A-6E show example circuit diagrams of a page buffer of FIG. 5A in different operation phases.
FIG. 7 shows a timing diagram illustrating voltage changes at different nodes of the page buffer during the operation phases of FIGS. 6A-6E.
FIG. 8A illustrates an example data transfer between a page buffer circuit and a cache data latch (CDL) circuit.
FIG. 8B shows a timing diagram illustrating voltage changes at different nodes of the page buffer circuit during the data transfer of FIG. 8A.
FIG. 9 is a flow chart of an example process for managing a page buffer circuit in a memory device, according to one or more implementations of the present disclosure.

Like reference numbers and designations in the various drawings indicate like elements. It is also to be understood that the various exemplary implementations shown in the figures are merely illustrative representations and are not necessarily drawn to scale.

### DETAILED DESCRIPTION

### Example Systems and Memory Devices

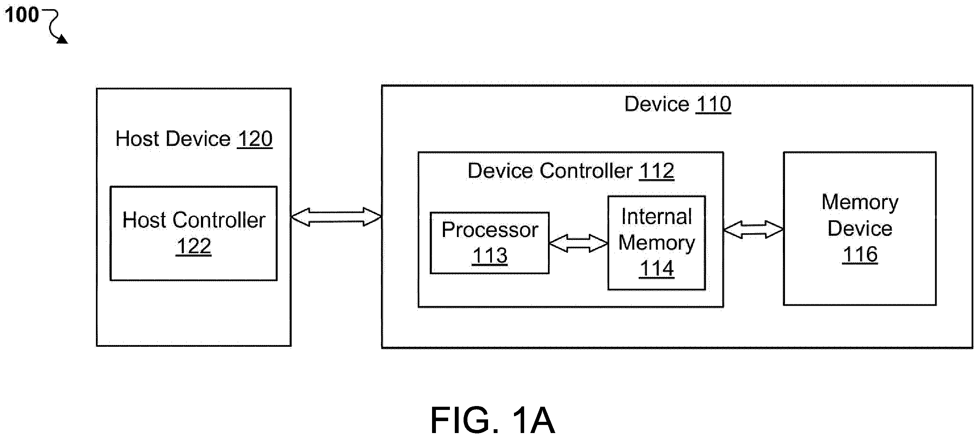

FIG. 1A illustrates an example of a system 100. The system 100 includes a device 110 and a host device 120. The device 110 includes a device controller 112 and a memory device 116. The device controller 112 includes a processor 113 and an internal memory 114. In some implementations, the device 110 includes a plurality of memory devices 116 that are coupled to the device controller 112. The host device 120 includes a host controller 122 that can include at least one processor and at least one memory coupled to the at least one processor and storing programming instructions for execution by the at least one processor to perform one or more corresponding operations.

In some implementations, the device 110 is a storage device. For example, the device 110 can be an embedded multimedia card (eMMC), a secure digital (SD) card, a solid-state drive (SSD), or some other suitable storage. In some implementations, the device 110 is a smart watch, a digital camera or a media player. In some implementations, the device 110 is a client device that is coupled to a host device 120. For example, the device 110 is an SD card in a digital camera or a media player that is the host device 120.

The device controller 112 is a general-purpose microprocessor, or an application-specific microcontroller. In some implementations, the device controller 112 is a memory controller for the device 110. The following sections describe the various techniques based on implementations in which the device controller 112 is a memory controller. However, the techniques described in the following sections are also applicable in implementations in which the device controller 112 is another type of controller that is different from a memory controller.

The processor 113 is configured to execute instructions and process data. The instructions include firmware instructions and/or other program instructions that are stored as firmware code and/or other program code, respectively, in the secondary memory. The data includes program data corresponding to the firmware and/or other programs executed by the processor, among other suitable data. In some implementations, the processor 113 is a general-purpose microprocessor, or an application-specific microcontroller. The processor 113 is also referred to as a central processing unit (CPU).

The processor 113 accesses instructions and data from the internal memory 114. In some implementations, the internal memory 114 is a Static Random Access Memory (SRAM) or a Dynamic Random Access Memory (DRAM). For example, in some implementations, when the device 110 is an eMMC, an SD card or a smart watch, the internal memory 114 is an SRAM. In some implementations, when the device 110 is a digital camera or a media player, the internal memory 114 is DRAM.

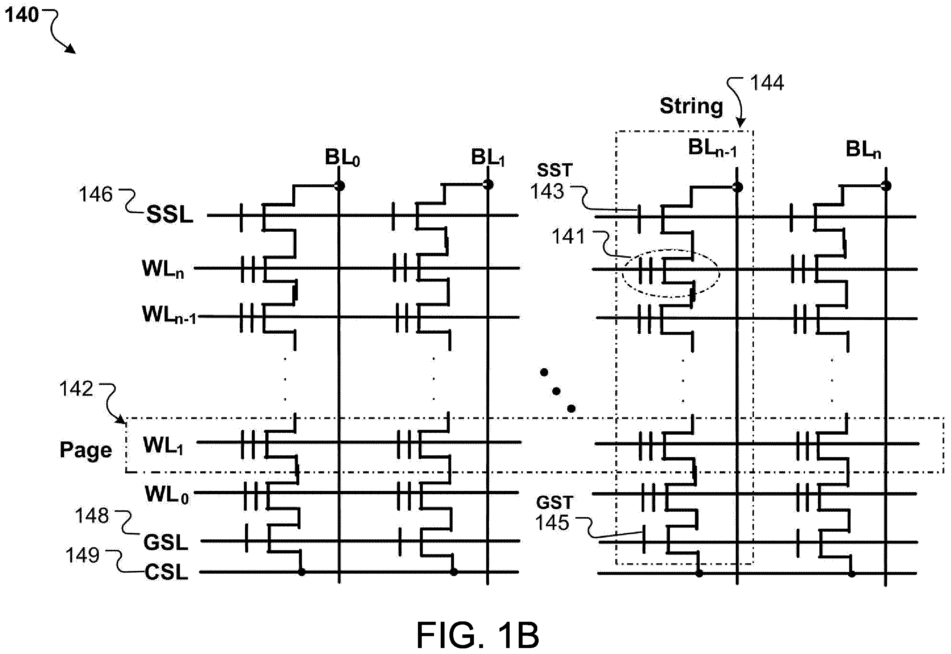

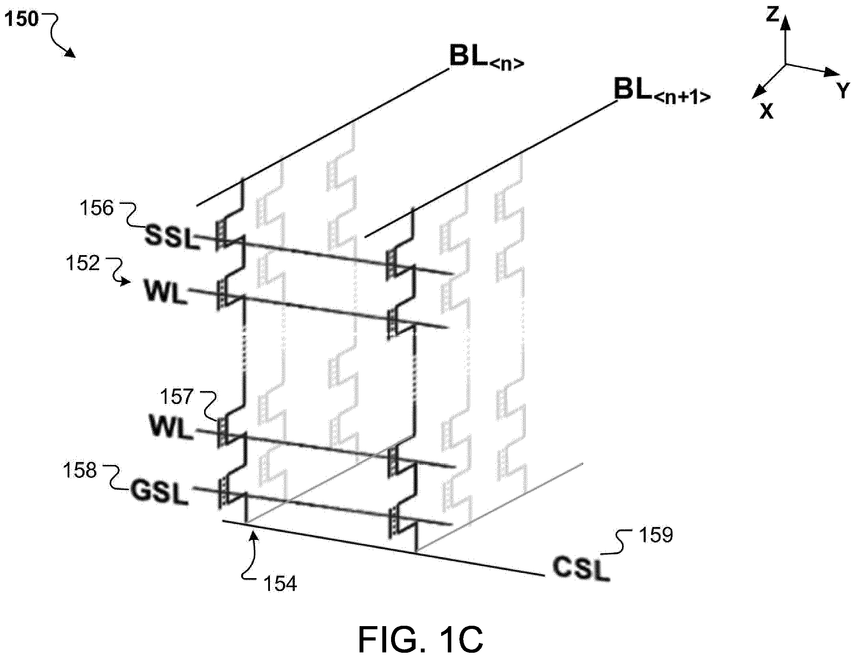

In some implementations, the internal memory is a cache memory that is included in the device controller 112, as shown in FIG. 1. The internal memory 114 stores instruction codes, which correspond to the instructions executed by the processor 113, and/or the data that are requested by the processor 113 during runtime.

The device controller 112 transfers the instruction code and/or the data from the memory device 116 to the internal memory 114. The memory device 116 can be a semiconductor device. In some implementations, the memory device 116 is a non-volatile memory that is configured for long-term storage of instructions and/or data, e.g., a NAND flash memory, or some other suitable non-volatile memory. In implementations where the memory device 116 is NAND flash memory, the device 110 is a flash memory, e.g., a flash memory card, and the device controller 112 is a NAND flash controller. For example, in some implementations, when the device 110 is an eMMC or an SD card, the memory device 116 is a NAND flash; in some implementations, when the device 110 is a digital camera, the memory device 116 is an SD card; and in some implementations, when the device 110 is a media player, the memory device 116 is a hard disk.

In some implementations, the device controller 112 is configured to receive data and instructions from and to send data to the host device 120. The device controller 112 is further configured to send data and commands to the memory device 116 and to receive data from the memory device 116. For example, the device controller 112 is configured to send data and a write command to instruct the memory device 116 to store the data to a specified address. As another example, the device controller 112 is configured to receive a read request (or a read command) from the host device 120 and send a corresponding read command to the memory device 116 to read data from a specified address in the memory device 116.

The memory device 116 includes a plurality of blocks. The memory device 116 can be a two-dimensional (2D) memory including 2D memory blocks, e.g., as described with further details in FIG. 1B. The memory device 116 can also be a three-dimensional (3D) memory including 3D memory blocks, e.g., as described with further details in FIG. 1C. Each block can include a same number of pages. Each page has a unique number in the block. Data is stored in the pages of the block according to the order of the unique numbers of the pages in the block. Each page can be read or written separately, and pages in a block can be erased together.

In some implementations, a block can be divided into a number of sub-blocks. Each sub-block can include one or more pages. Each page in a sub-block can be read or written separately. The one or more pages in each sub-block can be erased together. In some implementations, the memory device 116 includes one or more dies. Each die can be a memory chip and include a number of memory arrays and peripheral circuitry thereon. A memory array can include a number of planes, with each plane including a number of physical blocks of memory cells. Each physical block can include a number of pages of memory cells that can store a number of sectors of data. A super block can be specified, e.g., by a memory controller such as the device controller 112 of FIG. 1A, to combine at least one physical block from different planes. Each physical block in the super block comes from a different plane, that is, any plane cannot provide more than one block in the super block. The super block includes a number of super pages each combining multiple pages from the corresponding multiple physical blocks in the super block. Each page in a super page can have a same page number in its corresponding physical block. A super page can be programmed with all the pages in the super page being programmed simultaneously.

A memory cell can represent a number of states including an erased state and one or more programmed states. For example, in some cases, the memory cell is a single-level cell (SLC) that can store 1 bit and represent 2 states including an erased state (ER) and a programmed state (A). Memory cells in one word line can form one page. In some cases, the memory cell is a multi-level cell (MLC) such as a 2-level cell that can store 2 bits and represent 4 states including an erased state (ER) and three programmed states (A, B, and C). Memory cells in one word line can form two pages. In some cases, the memory cell is a triple-level cell (TLC) that can store 3 bits and represent 8 states including an erased state (ER) and seven programmed states (A, B, C, D, E, F, and G). Memory cells in one word line can form three pages. The states can have progressively higher voltage ranges, and the erased state has the lowest voltage rage.

FIG. 1B illustrates an example configuration of a 2D memory block 140 when the memory device 116 is a 2D memory. The 2D memory block 140 includes memory cells 141 coupled in series to column bit lines BL0, BL1, ..., BLn-1, and BLn to form a number of cell strings 144, and to row word lines WL0, WL1, ..., WLn-1, and WLn to form a number of cell pages 142.

Each memory cell in a block includes a transistor structure having a gate, a drain, a source, and a channel defined between the drain and the source. Each memory cell is located at an intersection between a word line and a bit line, where the gate is connected to the word line, the drain is connected to the bit line, and the source is connected to a source line, which in turn is connected to common ground. In some examples, the gate of a flash memory cell has a dual-gate structure, including a control gate and a floating gate, where the floating gate is suspended between two oxide layers to trap electrons that program the cell.

A cell string 144 can include a number of memory cells 141, a string select transistor (SST) 143, and a ground select transistor (GST) 145, which are all connected in series. A gate of the SST 143 is connected to a string select line (SSL) 146. Gates of the SSTs 143 in different strings are also connected to the same SSL. Gates of the memory cells 141 are respectively connected to row word lines WL0, WL1, ..., WLn-1, WLn. The cell strings 144 or the memory cells 141 are connected to a common source line (CSL) 149 via the ground select transistor (GST) 145. The common source line (CSL) 149 can be coupled to a ground or a supply voltage. A gate of the ground select transistor (GST) 145 is connected to a ground select line (GSL) 148. Gates of the ground select transistors (GSTs) 145 in different cell strings 144 are also connected to the same ground select line (GSL) 148.

A cell page 142 can include a number of memory cells 141. Gates of the memory cells 141 in the cell page 142 are coupled in series to a respective word line (WL). When an input voltage is applied to the word line, the input voltage is also applied to the gates of the memory cells 141 in the cell page 142. To read a particular cell page 142 in the 2D memory block 140 in a read operation, a lower read voltage is applied onto a word line corresponding to the particular cell page 142. Meanwhile, a higher read voltage is applied onto the other cell pages in the 2D memory block 140.

FIG. 1C illustrates an example 3D memory block 150 when the memory device 116 (shown in FIG. 1A) is a 3D memory. The 3D memory block 150 can include a stack of the 2D memory block 140 of FIG. 1B. Memory cells 157 are arranged in three dimensions, e.g., in an XYZ coordinate system, and coupled to a number of word lines to form a number of cell pages (conductive layers or word line layers) 152 and a number of bit lines (e.g., the column bit lines BL<n>, BL<n+1>) to form a number of cell strings 154. A cell page 152 can be a layer, e.g., in the XY plane, and memory cells 157 on the same layer can be coupled to one word line and have a same voltage. Each cell page 152 can be connected to a respective contact pad in a driving circuit, e.g., X-decoder (or a scanning driver).

A cell string 154 includes a number of memory cells 157 connected in series vertically along the Z direction, where a memory cell can be configured as an SST coupled to a string select line (SSL) 156 and a memory cell can be configured as a ground select transistor (GST) coupled to a ground select line (GSL) 158. The cell strings 154 are connected to one or more drivers, e.g., data drivers. The cell strings 154 of the memory cells 157 are connected to a common source line (CSL) 159 via the ground select transistors (GSTs). The common source line (CSL) 159 can be a conductive layer (or multiple conductive lines) formed on a substrate of the 3D memory. The common source line (CSL) 159 can be coupled to the ground or a supply voltage.

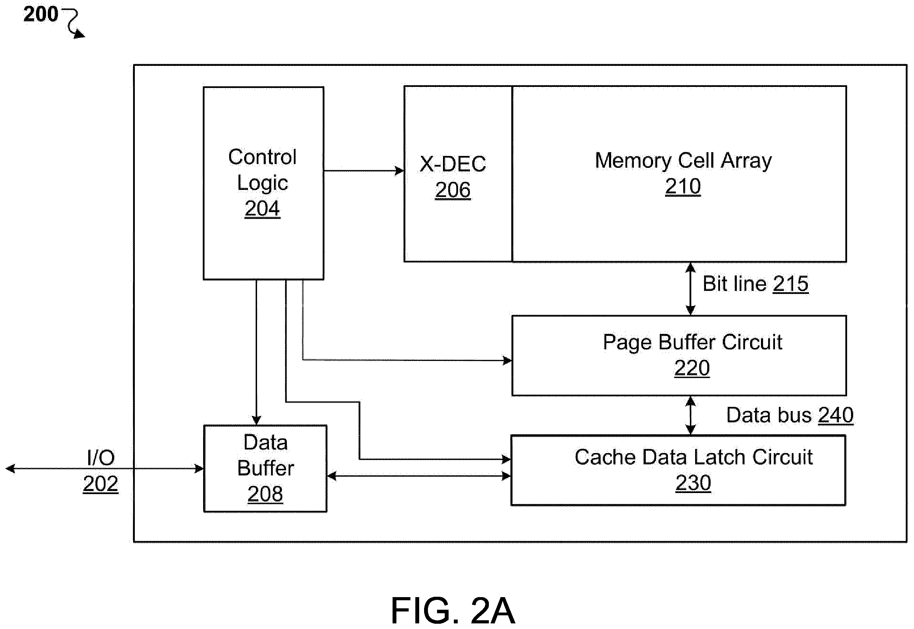

FIG. 2A illustrates an example configuration of a memory device 200. The memory device 200 can be implemented as the memory device 116 of FIG. 1A. The memory device 200 includes a memory cell array 210. The memory cell array 210 can include a number of memory cells, e.g., the memory cells 141 of FIG. 1B or the memory cells 157 of FIG. 1C, coupled in series to a number of row word lines and a number of column bit lines.

A memory cell can include a memory transistor configured as a storage element. The memory transistor can include a silicon-oxide-nitride-oxide-silicon (SONOS) transistor, a floating gate transistor, a nitride read only memory (NROM) transistor, or any suitable non-volatile memory metal-oxide-semiconductor (MOS) device that can store charges.

The memory device 200 includes a memory interface 202 having multiple input/output (I/O) ports for receiving data, e.g., from a controller such as the device controller 112 or the host controller 122 of FIG. 1A, or outputting data from the memory cell array 210. The memory device 200 includes a data buffer 208 configured to buffer data received and outputted through the memory interface 202.

The memory device 200 further includes an X-decoder (or row decoder) 206 and optionally a Y-decoder. Each memory cell is coupled to the X-decoder 206 via a respective word line and coupled to the Y-decoder via a respective bit line 215. Accordingly, each memory cell can be selected by the X-decoder 206 and the Y-decoder for read or write operations through the respective word line and the respective bit line 215.

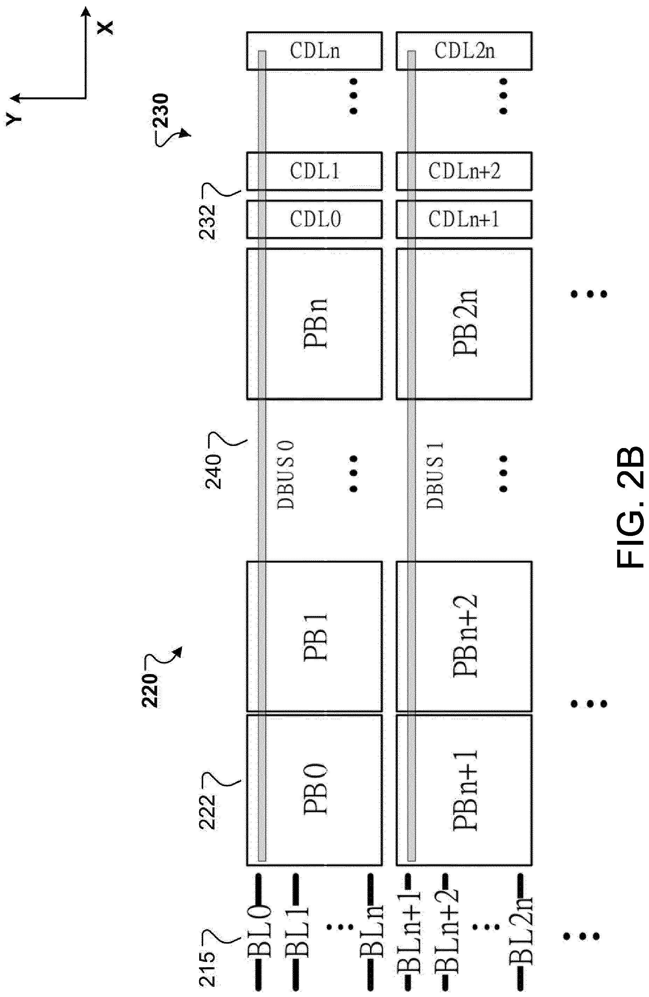

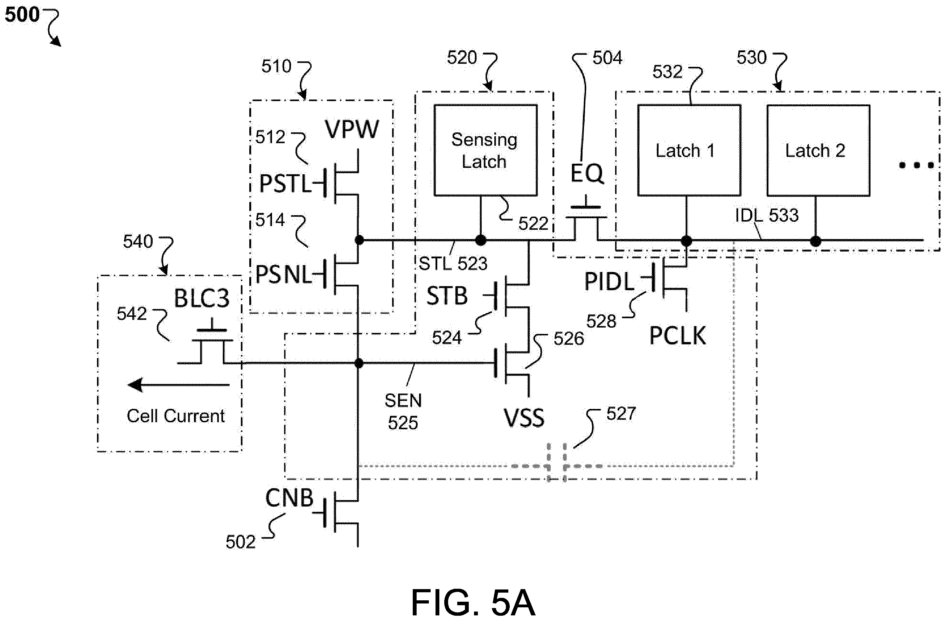

The memory device 200 includes a page buffer circuit 220 coupled to the memory cell array 210 through the bit lines 215 and a cache data latch (CDL) circuit 230 coupled to the page buffer circuit 220 through outer (or global) data bus 240. The data bus 240 can include one or more conductive lines (e.g., metal lines or metal routing). The page buffer circuit 220 can include a number of page buffers. Each page buffer can have a length along a horizontal direction (e.g., X direction) and a width along a vertical direction (e.g., Y direction), e.g., as illustrated in FIG. 2B. The page buffer includes multiple latches that can be made of a number of transistors. The transistors can be arranged along the length of the page buffer, e.g., the horizontal direction such as X direction. The transistors can be conductively connected with one another by inner metal routing lines in the page buffer, including, e.g., metal lines for DL, DLB, IDL, signal landing, and power landing, e.g., as described with further details in FIGS. 5A-5B.

FIG. 2B illustrates an example of the page buffer circuit 220 connected to the cache data latch (CDL) circuit 230 using the outer data bus 240. As an example, the page buffer circuit 220 includes 2*n page buffers 222 (page buffer PB0, PB 1, ..., PBn, PBn+1, PBn+2,..., PB2n) that can be separated into multiple columns or rows (e.g., 2), where n is an integer, e.g., in a range from 10 to 16. Each column or row can include n page buffers 222 that can be sequentially arranged along the lengths of the page buffers (e.g., the horizontal direction such as X direction). Each page buffer 222 (e.g., page buffer PB0, PB1, ..., PBn, PBn+1, PBn+2,..., PB2n) is coupled to the memory cell array 210 through a respective bit line 215 (e.g., column bit lines BL0, BL1,... BLn, BLn+1, BLn+2,..., BL2n), and coupled to a respective cache (e.g., cache CDL0, CDL1,..., CDLn, CDLn+1, CDLn+2,..., CDL2n) in the CDL circuit 230 through a corresponding data bus 240 (e.g., data bus DBUS_0 or DBUS_1). For example, page buffer PB0 is coupled to the memory cell array 210 through column bit line BL0 and coupled to cache CDL0 through the data bus DBUS_0. The respective bit lines 215 for a column or row of page buffers can be arranged along the width of the page buffer 222 (e.g., the vertical direction such as Y direction).

The data bus 240 is an outer (or global) metal line extending through the page buffer circuit 220 and through the CDL circuit 230. The data bus 240 can be coupled to each page buffer 222 in the page buffer circuit 220 and coupled to each cache 232 in the CDL circuit 230. A column or row of page buffers 222 sequentially arranged along the horizontal direction can share the same corresponding data bus 240. For example, the page buffers 222, PB0, PB1, ..., PBn, can be connected to the caches 232, CDL0, CDL1,..., CDLn, by the data bus DBUS_0, and the page buffers 222, PBn+1, PBn+2, ..., PB2n, can be connected to the caches 232, CDLn+1, CDLn+2,..., CDL2n, by the data bus DBUS_1.

With continued reference to FIG. 2A, in some embodiments, a page buffer 222 is connected to the Y-decoder through a data line associated with a corresponding bit line 215 that connects one or more memory cells in the memory cell array 210. The page buffer 222 can be configured to control a voltage on a corresponding bit line to perform an operation, e.g., read, program, or erase, on a memory cell coupled to the corresponding bit line 215. In some embodiments, during a program or erase operation, the CDL circuit 230 is configured to store data from the data buffer 208 and/or output to one or more page buffers 222 in the page buffer circuit 220. During a read operation, the CDL circuit 230 is configured to store data from one or more page buffers 222 in the page buffer circuit 220 and/or output data to the data buffer 208.

As shown in FIG. 2A, the memory device 200 can further include a control logic 204 coupled to components in the memory device 200 including the X-decoder 206 and the Y-decoder, the data buffer 208, the page buffer circuit 220, and the CDL circuit 230. The control logic 204 can be configured to receive a command, address information, and/or data, e.g., from a controller such as the device controller 112 or the host controller 122 of FIG. 1A, via the memory interface 202. The control logic 204 can also process the command, the address information, and/or the data, for example, to generate physical address information, e.g., of blocks/pages, in the memory cell array 210. The control logic 204 can include circuitry, e.g., an integrated circuit integrating multiple logics, circuits, and/or components. In some implementations, the control logic 204 includes at least one of a data register, an SRAM buffer, an address generator, a mode logic, or a state machine. The mode logic can be configured to determine whether there is a read or write operation and provide a result of the determination to the state machine.

During a write operation, the data register in the control logic 204 can register input data from the memory interface 202, and the address generator in the control logic 204 can generate corresponding physical addresses to store the input data in specified memory cells of the memory cell array 210. The address generator can be connected the X-decoder 206 and the Y-decoder that are controlled to select the specified memory cells through corresponding word lines and bit lines. The SRAM buffer can retain the input data from the data register in its memory as long as power is being supplied. The state machine can process a write signal from the SRAM buffer and provide a control signal to a voltage generator that can provide a write voltage to the X-decoder 206 and/or the Y-decoder. The Y-decoder is configured to output the write voltage to the bit lines (BLs) for storing the input data in the specified memory cells.

During a read operation, the state machine can provide control signals to the voltage generator and the page buffer circuit 220. The voltage generator can provide a read voltage to the X-decoder 206 and the Y-decoder for selecting a memory cell. A page buffer 222 can sense a small power signal (e.g., a current signal) that represents a data bit ("1" or "0") stored in the selected memory cell through a bit line 215 coupled to the page buffer 222 and the selected memory cell. A sense amplifier can amplify the small power signal swing to recognizable logic levels so the data bit can be interpreted properly by logic inside or outside the memory device 200. In some implementations, at least one of the page buffer circuit 220 or the CDL circuit 230 is included in the sense amplifier. The data buffer 208 can receive the amplified voltage from the sensor amplifier and output the amplified power signal to the logic outside the memory device 200 through the memory interface 202.

To sense data stored in a memory cell by sensing a current through a corresponding bit line, a page buffer can have a sensing capacitor on a sensing node for precharging and discharging at the sensing node. During a precharging phase of the page buffer, the sensing capacitor on the sensing node is precharged to have a predetermined sensing voltage. Then during a discharging phase following the precharging phase, charges stored in the sensing capacitor is discharged by a sensing current flowing to the memory cell via a corresponding bit line. Bit values latches in one or more latches in the page buffer can be updated based on a discharged sensing voltage (V_{SEN}) at the sensing node.

During a sensing phase (or a strobing phase) following the discharging phase, if the memory cell stores a bit "0", the discharged sensing voltage (V_{SEN}) at the sensing node can be greater than a predetermined threshold voltage (V_{Th}), e.g., a strobe voltage (V_{Strobe}) associated with latches in the page buffer. Accordingly, the page buffer can be configured to update a bit value "1" latched in the one or more latches to sensing value "0" or to strobe the sensing value "0" to the one or more latches. In contrast, if the memory cell stores a bit "1", the discharged sensing voltage (V_{SEN}) at the sensing node can be smaller than or equal to the predetermined threshold voltage (V_{Th}). Accordingly, the page buffer can be configured to maintain (or keep) the bit value "1" latches in the one or more latches.

If the capacitance at the sensing node is not stable and changes dramatically, e.g., near the threshold voltage (V_{Th}), the sensing result may be wrong. If the capacitance at the sensing node is small, the precharging and discharging phases cannot be fully performed for sensing. Thus, it is desirable for the page buffer to have a large and stable capacitance for the capacitor on the sensing node to be fully and stably precharged and discharged to thereby achieve accurate sensing. In some implementations, a transistor, e.g., a metal-oxide-semiconductor field-effect transistor (MOSFET), is used as a capacitor (e.g., a MOS capacitor) coupled to the sensing node in a page buffer. However, the transistor having a large capacitance tends to have a large size occupying a large area, which makes a total area of the page buffer increase.

Implementations for the present disclosure provide techniques for managing page buffer circuits in memory devices, for example, by providing a page buffer that uses existed metal routing (e.g., data bus (DBUS) metal routing), without using any extra metal routing, to replace an actual capacitor at a sensing node in the page buffer.

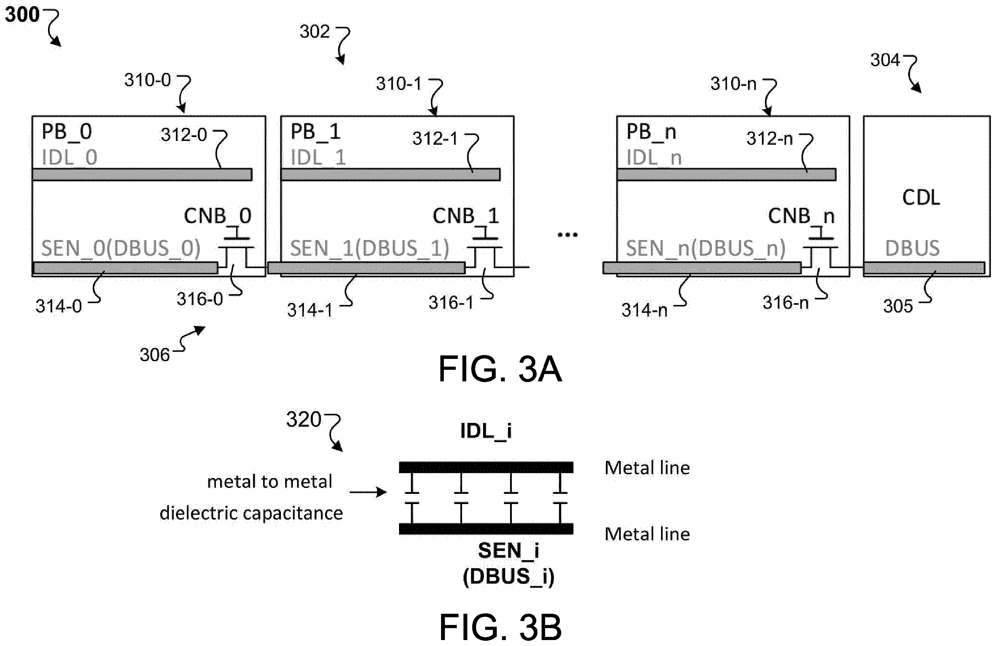

The existed metal routing, e.g., DBUS metal routing such as 240 of FIGS. 2A-2B, is configured to transfer data between page buffers in a page buffer circuit (e.g., the page buffer circuit 220 of FIGS. 2A-2B) and caches in a cache data latch (CDL) circuit (e.g., the CDL circuit 230 of FIGS. 2A-2B) by passing through the page buffer circuit and the CDL circuit. In some embodiments, e.g., as described with further details in FIG. 3A, the existed DBUS metal routing can be cut apart into a series of DBUS sections (or partial DBUS metal lines) by each page buffer length, e.g., using first connection transistors coupled between adjacent page buffers or adjacent DBUS sections.

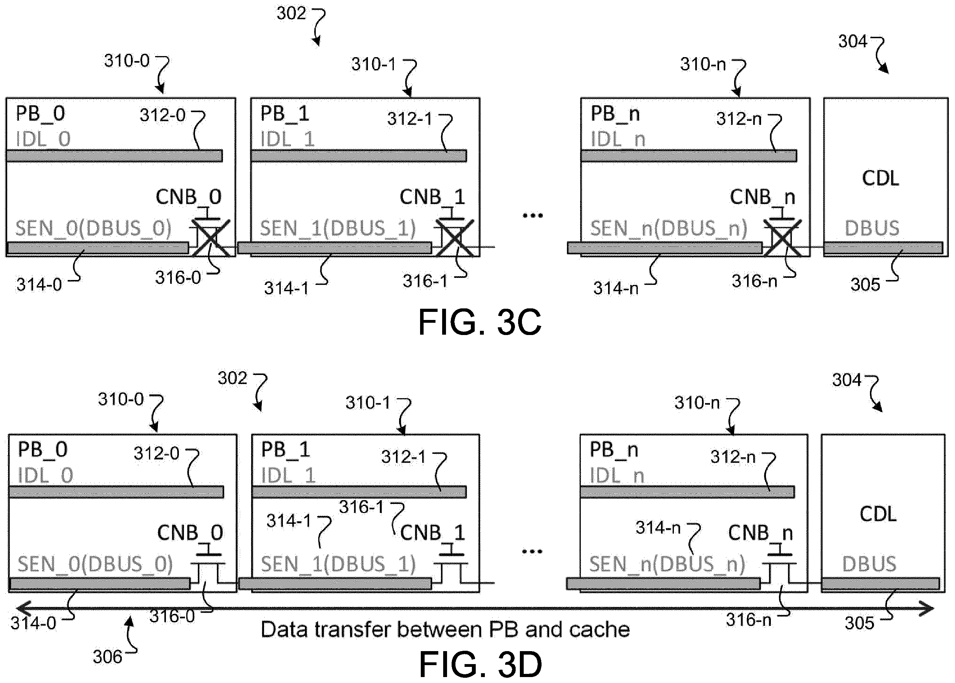

In a normal operation (e.g., a read operation), e.g., as described with further details in FIG. 3C, the first connection transistors are turned off, and each DBUS section is used as a sensing node for a corresponding page buffer. The sensing node can have a sensing capacitance formed by a parasitic capacitor defined between the DBUS section and one or more inner metal lines (e.g., inner data line such as IDL metal line) in the corresponding page buffer, without using an extra capacitor and any extra routing resource, e.g., as described with further details in FIG. 3B.

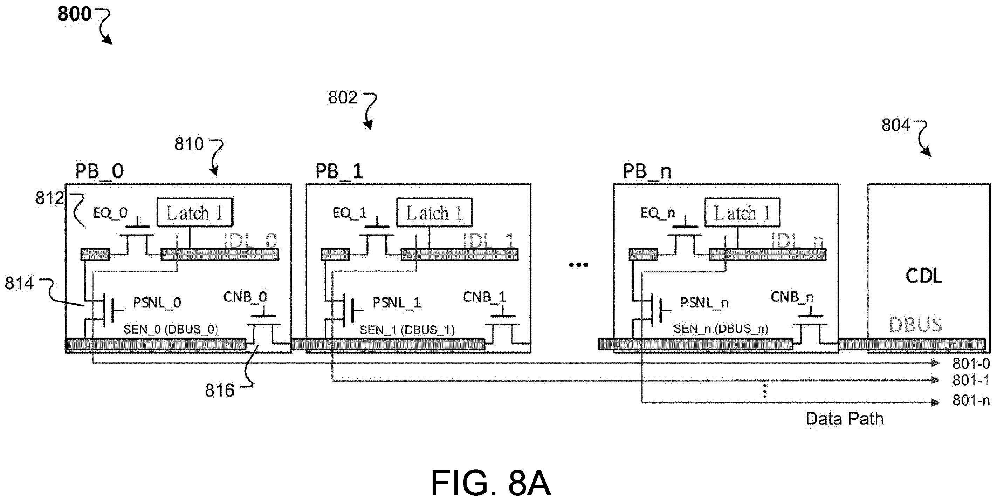

In a data transfer operation, e.g., as described with further details in FIG. 3D, all the first connection transistors are turned on to be connected together, and the series of DBUS sections are thus sequentially and conductively connected together as an integrated DBUS to transfer data between page buffers in the page buffer circuit and caches in the CDL circuit. Each page buffer can include an additional transistor, different from the first connection transistor, that can be individually and optionally sequentially turned on to transfer data from the page buffer to a corresponding cache in the CDL circuit via the same integrated DBUS, e.g., as described with further details in FIGS. 8A-8B.

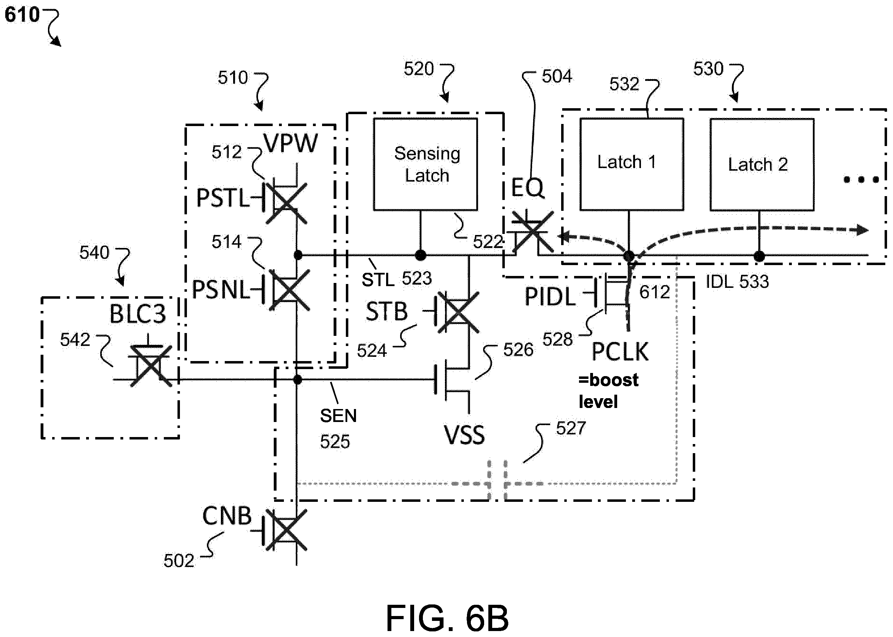

The page buffer with the parasitic capacitor at the sensing node can also implement voltage boosting to overcome a voltage gap between a bit line operation bias and a sensing strobing bias, e.g., as described with further details in FIGS. 6B-6D. In some embodiments, the inner metal line, e.g., IDL, connects latches in the page buffer and passes through the page buffer, and can be used with a corresponding DBUS section (e.g., used as the sensing node) via a metal line coupling effect to achieve the voltage boosting at the sensing node.

Each DBUS section in a page buffer region can include at least two sub-sections, e.g., a non-coupling noise sub-section and a coupling noise sub-section. The non-coupling noise sub-section of the partial DBUS section can be arranged adjacent to an inner metal line (e.g., IDL) to form the parasitic capacitor. The coupling noise sub-section of the partial DBUS section can suffer unexpected metal line to metal line coupling noise, e.g., due to being adjacent to a bit line. In some embodiments, the two sub-sections of each DBUS section are connected via a second connection transistor (or a section transistor), and thus the coupling noise sub-section can be configured to be conductively separated from the non-coupling noise sub-section during the normal operation of the page buffer, and conductively connected with the non-coupling noise sub-section during the data transfer operation.

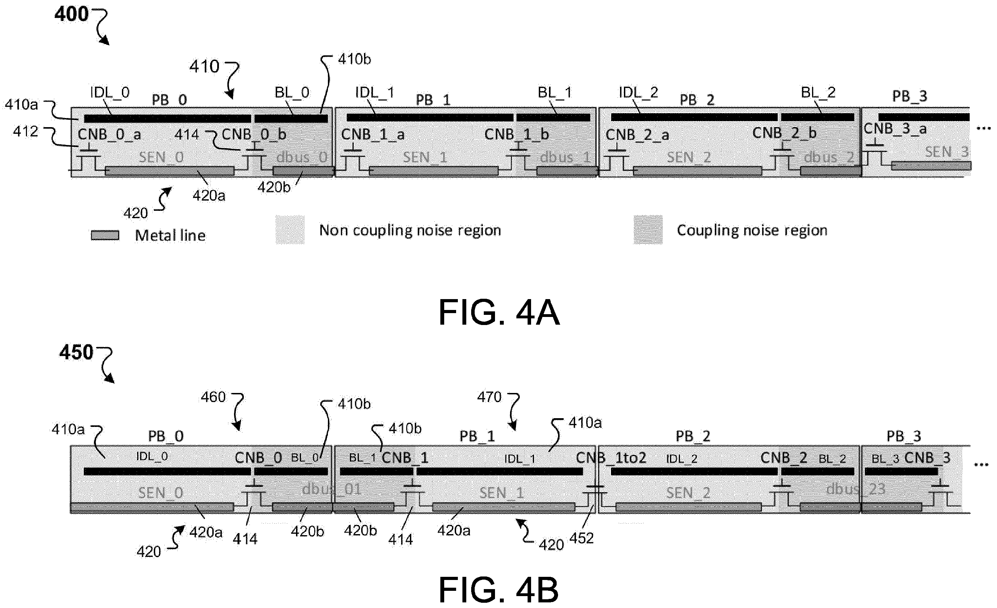

In some embodiments, each page buffer includes the first connection transistor and the second connection transistor, and the page buffers in the page buffer circuit are connected together in a sequence arrangement, e.g., as described with further details in FIG. 4A. In some embodiments, the page buffer circuit includes a number of pairs of adjacent page buffers that are connected together in a mirror arrangement, e.g., as described with further details in FIG. 4B. Each pair includes first and second page buffers. Coupling noise sub-sections of the first and second page buffers are connected together. A non-coupling noise sub-section of each of the first and second page buffers is coupled to a non-coupling noise sub-section of another page buffer in another pair through a first connection transistor. In such a way, each pair in the mirror arrangement can include three transistors (two second connection transistors and one first connection transistor), which can include less transistors than two adjacent page buffers in the sequence arrangement having four transistors (two second connection transistors and two first connection transistors).

### Example Integrated Circuits

FIG. 3A illustrates an example integrated circuit 300 including a page buffer circuit 302 and a cache data latch (CDL) circuit 304 that are connected by a data bus 306 formed by a series of data bus (DBUS) sections. The page buffer circuit 302 can be the page buffer circuit 220 of FIGS. 2A-2B. The CDL circuit 304 can be the CDL circuit 230 of FIGS. 2A-2B. The data bus 306 can be implemented as the data bus 240 of FIGS. 2A-2B.

As shown in FIG. 3A, the page buffer circuit 310 includes a number of page buffers PB_0/310-0, PB_1/310-1, ..., PB n/310-n (referred to generally as page buffers 310 and individually as page buffer 310), where n is an integer. The page buffers 310 can be sequentially arranged along a direction, e.g., along a length of the page buffers as illustrated in FIG. 2B. Each page buffer 310 includes multiple conductive lines (e.g., metal lines) for connecting components (e.g., transistors) in the page buffer 310, e.g., as illustrated with further details in FIGS. 5A-5B. For example, each page buffer 310-0, 310-1, ..., or 310-n can include a respective internal data line (IDL) IDL-0/312-0, IDL-1/312-1, ..., IDL-n/312-n (referred to generally as IDLs 312 and individually as IDL 312). The IDL 312 can be configured to connect a plurality of latches in the page buffer 310, e.g., as illustrated in FIG. 5A, for internal data operations/transfers, e.g., transferring data between latches and/or transferring data out to the CDL circuit 304.

As illustrated in FIG. 3A, each page buffer 310 can include a sensing node SEN_0/314-0, SEN_1/314-1,..., SEN_n/314-n (referred to generally as sensing nodes 314 and individually as sensing node 314). The sensing node 314 can be a conductive line, e.g., a metal line, in the page buffer 310. The sensing node 314 can be coupled to a bit line (e.g., the bit line as described in FIG. 1B or 1C, or the bit line 215 of FIGS. 2A-2B) for sensing data.

In some embodiments, as shown in FIG. 3A, the sensing node 314, e.g., sensing node SEN_0, SEN_1, ..., SEN_n, in each page buffer 310 can be used as a partial data bus DBUS_0, DBUS_1, ..., DBUS_n (referred to generally as DBUSs 314 and individually as DBUS 314)). The series of data bus sections 314, e.g., the data bus DBUS_0, DBUS_1, ..., DBUS_n, in the page buffer circuit 302 and DBUS 305 in the CDL circuit 304 can be connected together through a plurality of connection transistors 316-0, 316-1,..., 316-n (referred to generally as connection transistors 316 and individually as connection transistor 316) to form the data bus 306. The DBUS 305 can be a conductive line (e.g., a metal line) connected to multiple caches in the CDL circuit 304.

In some embodiments, the connection transistor 316 is included in a corresponding page buffer 310, e.g., as illustrated in FIG. 3A. For example, page buffer 310-0 includes connection transistor 316-0 coupled between the sensing node 314-0 and adjacent sensing node 314-1 in page buffer 310-1 subsequent to page buffer 310-0. In some embodiments, the connection transistor 316 is positioned between adjacent page buffers 310 but external to the adjacent page buffers 310.

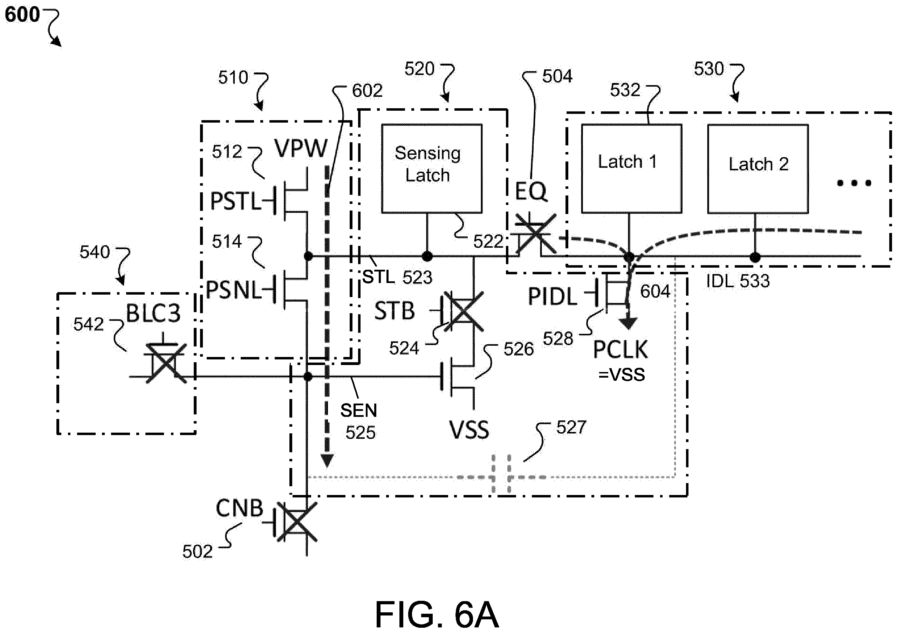

Conductive lines (e.g., made of a metal material such as tungsten W) in the page buffer 310 can be insulated from one another by an insulating material (e.g., a dielectric material such as silicon oxide). In some embodiments, in the page buffer 310, the IDL 312 and the sensing node (or the DBUS section) 314 can be two parallel conductive lines (e.g., metal lines) and can be positioned adjacent to each other and separated from each other by the insulating material. In such a way, as illustrated in FIG. 3B, a parasitic capacitor 320 can be formed between the IDL 312 (e.g., IDL_i) and the sensing node (or the DBUS section) 314 ( e.g., sensing node SEN_i or data bus DBUS_i) in the page buffer 310, where i is 0, 1, ..., n. If the IDL 312 and the sensing node (or the DBUS section) 314 are metal lines separated by a dielectric material, the formed parasitic capacitor 320 has a capacitance that can be used as a sensing capacitance. Accordingly, the parasitic capacitor 320 coupled to the sensing node 314 can function as a sensing capacitor that can be charged or discharged for data sensing as discussed with further details in FIGS. 6A-6E. Thus, the page buffer 310 can include the parasitic capacitor 320 for data sensing, without using any actual sensing capacitor.

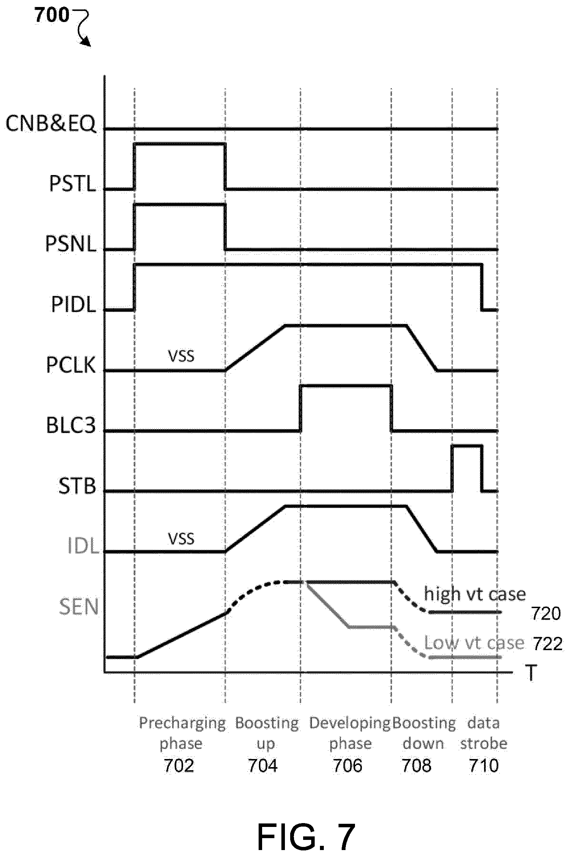

Each connection transistor 316 has first and second terminals coupled to adjacent DBUS sections 314 and a gate terminal configured to receive a control signal CNB_0, CNB_1, ..., CNB_n (referred to generally as control signals CNB and individually as referred to control signal CNB). The connection transistor 316 can be turned on or off based on the control signal CNB, e.g., as described with further details in FIG. 7.

FIG. 3C illustrates an example normal operation mode of the integrated circuit 300 of FIG. 3A. In a normal operation (e.g., a read operation), the connection transistors 316 are turned off, and each DBUS section is used as a sensing node 314 for a corresponding page buffer 310. The sensing node 314 can have a sensing capacitance formed by a parasitic capacitor 320 defined between the DBUS section 314 and the IDL 312 in the corresponding page buffer 310. The normal operation can be described with further details in FIGS. 6A-6E.

FIG. 3D illustrates an example data transfer mode of the integrated circuit of FIG. 3A. In a data transfer operation, the connection transistors 316 are turned on, and the series of DBUS sections 314 and 305 are thus sequentially and conductively connected together as an integrated DBUS 306 to transfer data between page buffers 310 in the page buffer circuit 302 and caches in the CDL circuit 304. Each page buffer 310 can include an additional transistor, different from the connection transistor 316, that can be individually and optionally sequentially turned on to transfer data from the page buffer 310 to a corresponding cache in the CDL circuit 304 via the same integrated DBUS 306, e.g., as described with further details in FIGS. 8A-8B.

A whole DBUS section (e.g., DBUS section 314) in a page buffer (e.g., page buffer 310) can be used to form a parasitic capacitor with a sensing capacitance. However, in some regions of the page buffer (e.g., where a partial DBUS section is positioned adjacent to a bit line), coupling noise (e.g., between the bit line and the partial DBUS section) can occur.

In some embodiments, as illustrated in FIGS. 4A-4B, a page buffer 410 (e.g., page buffer PB_0) can be characterized to include at least two regions, including a non-coupling-noise region 410a and a coupling noise region 410b. A corresponding DBUS section 420 can be separated into at least two sub-sections, e.g., a non-coupling noise DBUS sub-section 420a in the non-coupling noise region 410a and a coupling noise DBUS sub-section 420b in the coupling noise region 410b.

In the non-coupling-noise region 410a, the non-coupling noise DBUS sub-section 420a can be used as a sensing node (e.g., sensing node SEN_0) for the page buffer 410. The non-coupling noise DBUS sub-section 420a can be positioned adjacent to an inner metal line (e.g., the internal data line IDL_0, such as the internal data line 312 of FIGS. 3A-3D) to form a corresponding parasitic capacitor (e.g., the parasitic capacitor 320 of FIG. 3B). In the coupling-noise region 410b, the coupling noise DBUS sub-section 420b may be positioned adjacent to another inner metal line (e.g., column bit line BL_0), which may cause coupling noise. Thus, the coupling noise DBUS sub-section 420b is not suitable for forming a parasitic capacitor and can be used only as part of a data bus for data transfer (e.g., data bus dbus_0).

In some embodiments, as illustrated in FIGS. 4A-4B, the page buffer 410 (e.g., page buffer PB_0) can include a second connection transistor (or a section transistor) 414 coupled between the non-coupling noise DBUS sub-section 420a and the coupling noise DBUS sub-section 420b. The second connection transistor 414 has first and second terminals separately coupled to the non-coupling noise DBUS sub-section 420a and the coupling noise DBUS sub-section 420b and a gate terminal for receiving a control signal (e.g., control signal CNB_0_b) to turn on or off the second connection transistor 414. During a normal operation (e.g., as illustrated in FIG. 3C), the second connection transistor 414 is turned off such that the non-coupling noise DBUS sub-section 420a is used as the sensing node to form the parasitic capacitor for data sensing, while the coupling noise DBUS sub-section 420b is not used. During a data transfer operation (e.g., as illustrated in FIG. 3D), the second connection transistor 414 is turned on such that the non-coupling noise DBUS sub-section 420a and the coupling noise DBUS sub-section 420b are conductively connected to form an integrated DBUS section 420 for data transfer.

FIG. 4A illustrates an example page buffer circuit 400 with a sequence page buffer placement. The page buffer circuit 400 can be implemented as the page buffer circuit 220 of FIGS. 2A-2B or be the page buffer circuit 302 of FIGS. 3A-3D. The page buffer circuit 400 can include a plurality of page buffers 410, e.g., page buffers PB_0, PB_1, PB_2, PB_3. The page buffer 410 can be the page buffer 222 of FIG. 2B or the page buffer 310 of FIGS. 3A-3D. The page buffers 410 are sequentially arranged in the page buffer circuit 400.

Each page buffer 410, e.g., page buffer PB_0, PB_1, PB_2, PB_3, can have a same configuration, e.g., including a first connection transistor 412 and a second connection transistor 414. The second connection transistor 414 can be an intra-connector coupled between a non-coupling noise DBUS sub-section 420a and a coupling noise DBUS sub-section 420b in the page buffer 410. In contrast, the first connection transistor 412 can be an inter-connector coupled between two page buffers 410, e.g., between a coupling noise DBUS sub-section 420b of a preceding page buffer and the non-coupling noise DBUS sub-section 420a in a current page buffer. The first connection transistor 412 can be the connection transistor 316 of FIGS. 3A, 3C-3D, and can be configured to receive a control signal (e.g., control signal CNB_0_a) for turning on or off the first connection transistor 412.

During a normal operation (e.g., as illustrated in FIG. 3C), both the first connection transistor 412 and the second connection transistor 414 in each page buffer 410 are turned off, such that the non-coupling noise DBUS sub-section 420a in each page buffer 410 is used as the sensing node to form the parasitic capacitor for data sensing. During a data transfer operation (e.g., as illustrated in FIG. 3D), both the first connection transistor 412 and the second connection transistor 414 in each page buffer 410 are turned on such that the non-coupling noise DBUS sub-section 420a and the coupling noise DBUS sub-section 420b are conductively connected to form an integrated DBUS section 420, and all the integrated DBUS sections 420 are conductively connected together to form an integrated DBUS (e.g., the data bus 240 of FIGS. 2A-2B or DBUS 306 of FIG. 3D) for data transfer.

FIG. 4B illustrates another example page buffer circuit 450 with a mirror page buffer placement. Different from the page buffer circuit 400 of FIG. 4A where each page buffer 410 has the same configuration and is sequentially arranged, the page buffer circuit 450 includes multiple pairs of first page buffer 460 and second page buffer 470 (e.g., a first pair of page buffers PB_0 and PB_1, and a second pair of page buffers PB_2 and PB_3) that are arranged in the mirror page buffer placement.

Each of the first page buffer 460 and the second page buffer 470 can be similar to the page buffer 410 of FIG. 4A, and can include a second connection transistor 414 coupled between a non-coupling noise DBUS sub-section 420a and a coupling noise DBUS sub-section 420b in the first page buffer 460 or the second page buffer 470. However, different from the page buffer circuit 400 of FIG. 4A, in the page buffer circuit 450, the coupling noise DBUS sub-sections 420b in adjacent page buffers (e.g., page buffers PB_0 and PB_1, or page buffers PB_2 and PB_3) in the same pair are conductively connected together or are a single continuous conductive line (e.g., data bus dbus_01 or dbus_23). The non-coupling noise DBUS sub-section 420a (e.g., sensing node SEN_1) in the second page buffer 470 (e.g., page buffer PB_1) is coupled to a non-coupling noise DBUS sub-section (e.g., sensing node SEN_2) in a following page buffer (e.g., page buffer PB_2) in a following pair (e.g., page buffers PB_2 and PB_3) by a first connection transistor 452. Or the non-coupling noise DBUS sub-section 420a (e.g., sensing node SEN_2) in the second page buffer 470 (e.g., page buffer PB_2) is coupled to a non-coupling noise DBUS sub-section (e.g., sensing node SEN_1) in a preceding page buffer (e.g., page buffer PB_1) in a preceding pair by a first connection transistor 452. That is, adjacent pairs of first and second page buffers are coupled together using a corresponding first connection transistor 452.

The corresponding first connection transistor 452 can be positioned at a beginning of the first page buffer 460 (e.g., page buffer PB_2) in a pair or at an end of the second page buffer 470 (e.g., page buffer PB_1) in a pair, or between the adjacent pairs (e.g., between the first pair of page buffers PB_0 and PB_1 and the second pair of page buffers PB_2 and PB_3). The first connection transistor 452 can be similar to the connection transistor 316 of FIGS. 3A, 3C-3D or the first connection transistor 412 of FIG. 4A, and can be configured to receive a control signal (e.g., control signal CNB_1to2) for turning on or off the first connection transistor 452. In such a way, each pair in the mirror arrangement in the page buffer circuit 450 can include three transistors (two second connection transistors 414 and one first connection transistor 452). In contrast, two adjacent page buffers in the sequence arrangement in the page buffer circuit 400 of FIG. 4A have four transistors (two second connection transistors 414 and two first connection transistors 412). Thus, the page buffer circuit 450 can use less transistors than the page buffer circuit 400.

The page buffer circuit 450 can be operated similar to the page buffer circuit 400. During a normal operation (e.g., as illustrated in FIG. 3C), all the first connection transistors 452 and the second connection transistors 414 in the page buffer circuit 450 are turned off, such that the non-coupling noise DBUS sub-section 420a in each page buffer is used as the sensing node to form the parasitic capacitor for data sensing. During a data transfer operation (e.g., as illustrated in FIG. 3D), all the first connection transistors 452 and the second connection transistors 414 in the page buffer circuit 450 are turned on such that the non-coupling noise DBUS sub-section 420a and the coupling noise DBUS sub-section 420b are conductively connected to form an integrated DBUS section 420, and all the integrated DBUS sections 420 are conductively connected together to form an integrated DBUS (e.g., the data bus 240 of FIGS. 2A-2B or the data bus 306 of FIG. 3D) for data transfer.

### Example Page Buffer

FIG. 5A is a circuit diagram illustrating an example page buffer 500 in a page buffer circuit. The page buffer circuit can be the page buffer circuit 220 of FIGS. 2A-2B, the page buffer circuit 302 of FIGS. 3A-3D, the page buffer circuit 400 of FIG. 4A, or the page buffer circuit 450 of FIG. 4B. The page buffer 500 can be the page buffer 222 of FIG. 2B, the page buffer 310 of FIGS. 3A-3D, the page buffer 410 of FIG. 4A, or the first page buffer 460 or the second page buffer 470 of FIG. 4B. The page buffer 500 can be configured to have a parasitic capacitor (e.g., the parasitic capacitor 320 of FIG. 3B) and can implement voltage boosting for data sensing.

The page buffer 500 can include a connection transistor 502 that is configured to connect to an adjacent page buffer in the page buffer circuit, e.g., as described in FIGS. 3A,3C-3D, 4A or 4B. The connection transistor 502 can be coupled between two DBUS sections (e.g., DBUS section 314 of FIG. 3A, 3C or 3D, the first connection transistor 412 of FIG. 4A or the first connection transistor 452 of FIG. 4B) in the page buffer 500 and the adjacent page buffer. The connection transistor 502 is configured to receive, at a gate terminal, a control signal CNB for turning off the connection transistor 502 during a normal operation mode (e.g., as illustrated in FIG. 3C) or turning on the connection transistor 502 during a data transfer mode (e.g., as illustrated in FIG. 3D).

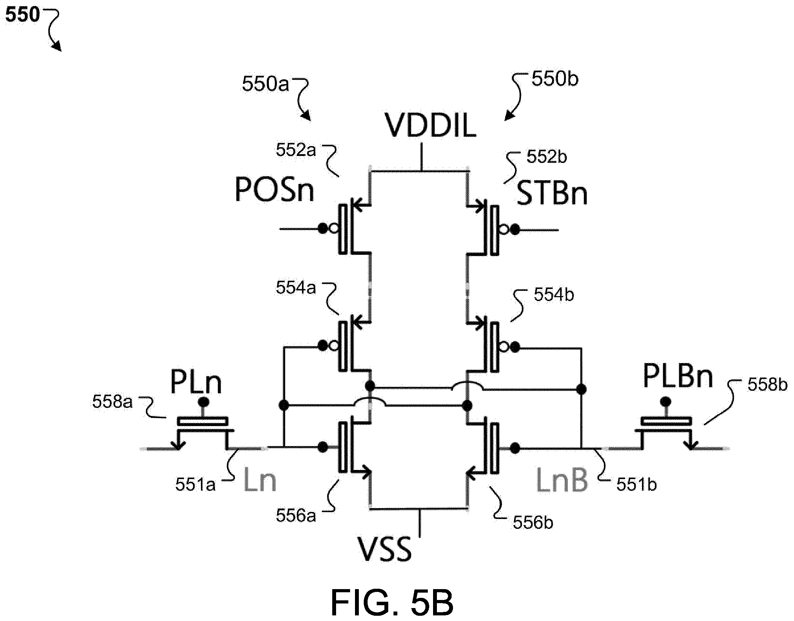

In some embodiments, the sensing circuit 520 includes a sensing latch 522, a first transistor 524, and a second transistor 526. The sensing latch 522 and the storing latch 532 can have a same configuration, e.g., as described with further details in FIG. 5B. The sensing latch 522 is coupled to a conductive line (STL) 523 that is coupled to the IDL 533 through the latch transistor 504. The first transistor 524 and the second transistor 526 are coupled in series between the conductive line (STL) 523 and a lower supply voltage VSS. The first transistor 524 is configured to receive a strobe signal STB for turning on or off the first transistor 524. A gate terminal of the second transistor 526 is coupled to the bit line control circuit 540 by a conductive line that can be considered as a sensing node (SEN) 525. The sensing node 525 is also coupled to the connection transistor 502. As noted above, the sensing node 525 can be used as a DBUS section in the page buffer 500. The sensing node 525 can be positioned adjacent to the IDL 533 and isolated from the IDL 533 by an insulating material (e.g., a dielectric material) to form a parasitic capacitor 527 (e.g., the parasitic capacitor 320 of FIG. 3B) that can be used as a sensing capacitor for data sensing.

In some embodiments, the sensing circuit 520 includes a sensing latch 522, a first transistor 524, and a second transistor 526. The sensing latch 522 and the storing latch 532 can have a same configuration, e.g., as described with further details in FIG. 5B. The sensing latch 522 is coupled to a conductive line STL 523 that is coupled to the IDL 533 through the latch transistor 504. The first transistor 524 and the second transistor 526 are coupled in series between the conductive line STL 523 and a low supply voltage VSS. The first transistor 524 is configured to receive a strobe signal STB for turning on or off the first transistor 524. A gate terminal of the second transistor 526 is coupled to the bit line control circuit 540 by a conductive line 525 that can be considered as a sensing node SEN 525. The sensing node 525 is also coupled to the connection transistor 502. As noted above, the sensing node 525 can be used as a DBUS section in the page buffer 500. The sensing node 525 can be positioned adjacent to the IDL 533 and isolated from the IDL 533 by an insulating material (e.g., a dielectric material) to form a parasitic capacitor 527 (e.g., the parasitic capacitor 320 of FIG. 3B) that can be used as a sensing capacitor for data sensing.

As shown in FIG. 5A, the precharging circuit 510 is coupled to the sensing node 525. The bit line control circuit 540 is configured to have a first control node coupled to a bit line (e.g., the bit line 215 of FIGS. 2A-2B) and a second control node coupled to the sensing node 525. As discussed with further details in FIG. 6A and FIG. 7 below, the precharging circuit 510 is configured to precharge the sensing node 525 during a precharging phase. The bit line control circuit 540 can be configured to precharge the bit line during the precharging phase and discharge the sensing node 525 during a developing (or discharging) phase after the precharging phase. The bit line control circuit 540 can include at least one transistor 542 configured to receive a control signal BLC3 for turning on or off the transistor 542 for controlling a cell current flow.

The precharging circuit 510 can include two transistors 512 and 514 (e.g., PMOS transistors) coupled in series between a supply voltage VPW and the sensing node 525. The transistor 512 has a first terminal for receiving the supply voltage VPW, a gate terminal for receiving a precharging control signal PSTL. The transistor 514 has a gate terminal for receiving a precharging enable signal PSNL, a first terminal coupled to a second terminal of the transistor 512, and a second terminal coupled to the sensing node 525. The sensing latch 522 can be coupled to the first terminal of the transistor 514 by the conductive line (STL) 523, such that the transistor 514 can be used as a switch for individually or sequentially transferring data from the storing latch circuit 530, e.g., as discussed with further details in FIGS. 8A-8B.

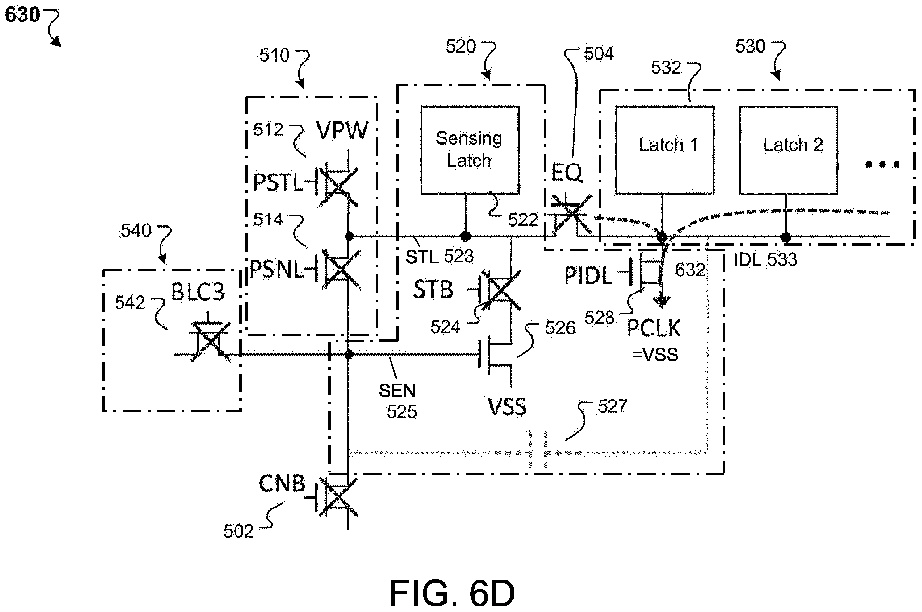

In some embodiments, the page buffer 500 includes a boosting circuit that can include a boosting transistor 528, e.g., an n-channel transistor such as NMOS transistor. The boosting transistor 528 has a first terminal coupled to the IDL 533, a gate terminal for receiving a control signal PIDL, and a second terminal coupled to a boosting signal PCLK. As discussed with further details in FIGS. 6B, 6D, and 7, a voltage level of the IDL 533 can be controlled based on a voltage level of the boosting signal PCLK.

FIG. 5B shows a circuit diagram illustrating an example latch 550 in a page buffer (e.g., the page buffer 500 of FIG. 5). The latch 550 can be the sensing latch 522 or the storing latch 532 of FIG. 5A. The latch 550 can be a tri-state latch or a fighting latch.

In some embodiments, as illustrated in FIG. 5B, the latch 550 is a tri-sate latch and can include a first side 550a and a second side 550b that are symmetric to each other. The first side 550a and the second side 550b are configured to receive a higher supply voltage VDDIL at one end and a lower supply voltage VSS at the other end. The first side 550a can include a first inverted p-type transistor 552a, a second inverted p-type transistor 554a, a first n-type transistor 556a, and a second n-type transistor 558a. The second side 550b can include a first inverted p-type transistor 552b, a second inverted p-type transistor 554b, a first n-type transistor 556b, and a second n-type transistor 558b.

For the first side 550a, the first inverted p-type transistor 552a includes a first terminal for receiving the higher supply voltage VDDIL, a second terminal coupled to the second inverted p-type transistor 554a, and a gate terminal for receiving a control signal POSn. The second inverted p-type transistor 554a includes a first terminal coupled to the second terminal of the first inverted p-type transistor 552a, a second terminal coupled to the first n-type transistor 556a and also to a gate terminal of the first n-type transistor 556b in the second side 550b, and a gate terminal coupled to a gate terminal of the first n-type transistor 556a and the second n-type transistor 558a. The first n-type transistor 556a includes a first terminal coupled to the second terminal of the second inverted p-type transistor 554a, a second terminal coupled to the lower supply voltage VSS, and the gate terminal to the gate terminal of the second inverted p-type transistor 554a and also to a node between the second inverted p-type transistors 554b, the first n-type transistor 556b in the second side 550b. The second n-type transistor 558a includes a first terminal coupled to the gate terminal of the first n-type transistor 556a, a second terminal coupled out to a data bus line (e.g., IDL), and a gate terminal for receiving a control signal PLn.

The second side 550b has a symmetric configuration as the first side 550a. The first inverted p-type transistor 552b includes a first terminal for receiving the higher supply voltage VDDIL, a second terminal coupled to the second inverted p-type transistor 554b, and a gate terminal for receiving a strobe signal STBn. The second inverted p-type transistor 554b includes a first terminal coupled to the second terminal of the first inverted p-type transistor 552b, a second terminal coupled to the first n-type transistor 556b and also to a gate terminal of the first n-type transistor 556a in the first side 550a, and a gate terminal coupled to a gate terminal of the first n-type transistor 556b and the second n-type transistor 558b. The first n-type transistor 556b includes a first terminal coupled to the second terminal of the second inverted p-type transistor 554b, a second terminal coupled to the lower supply voltage VSS, and the gate terminal to the gate terminal of the second inverted p-type transistor 554b and also to a node between the second inverted p-type transistors 554a, the first n-type transistor 556a in the first side 550a. The second n-type transistor 558b includes a first terminal coupled to the gate terminal of the first n-type transistor 556b, a second terminal coupled out to the data bus line (e.g., IDL), and a gate terminal for receiving a control signal PLBn.

A value corresponding to a voltage at LnB node 551b coupled between the second inverted p-type transistor 554b, the first n-type transistor 556b, the second n-type transistor 558b in the second side 550b is opposite to a value corresponding to a voltage at Ln node 551a coupled between the second inverted p-type transistor 554a, the first n-type transistor 556a, the second n-type transistor 558a in the first side 550a. The latch 550 can be configured to store data by updating the value at the LnB node 551b and/or the value at the Ln node 551a.

### Example Operations

FIGS. 6A-6E show example circuit diagrams of the page buffer 500 of FIG. 5A in different operation phases of a normal operation (e.g., a read operation). FIG. 7 shows a timing diagram 700 illustrating voltage changes at different nodes of the page buffer 500 during the operation phases of FIGS. 6A-6E, including precharging phase 702, boosting up phase 704, developing phase 706, boosting down phase 708, and data strobe phase 710.

As noted above, the connection transistor 502 can be turned off by the control signal CNB during the normal operation such that the parasitic capacitor 527 is formed between the sensing node 525 and the IDL 533 for the normal operation. The latch transistor 504 can be also turned off by the control signal EQ during the normal operation such that no data transfer between the sensing circuit 520 and the storing latch circuit 530.

During the precharging phase, as circuit diagram 600 of FIG. 6A and the precharging phase 702 of FIG. 7 show, the transistors 512 and 514 are turned on by receiving corresponding precharging control signal PSTL and precharging enable signals PSNL (e.g. at a high voltage level). Accordingly, the precharging circuit 510 is turned on to precharge the sensing node 525 from a lower voltage level to a higher voltage level. The sensing node 525 can be precharged by the supply voltage VPW via the transistors 512 and 514 along a current path 602.

During the precharging phase, the transistor 542 is turned off by a corresponding control signal BLC3 such that the bit line is conductively disconnected to the sensing node 525 and can be independently precharged by the bit line control circuit 540. During the precharging phase, the boosting transistor 528 is turned on by the corresponding control signal PIDL (e.g., at a high voltage level) and receives the boosting signal PCLK at a lower supply voltage VSS, such that a current path 604 flows from the IDL 533 to the second terminal of the boosting transistor 528 to cause the IDL 533 to be at a lower supply voltage VSS, as shown in FIG. 7. Thus, the parasitic capacitor 527 is precharged to have a sensing capacitance or a sensing voltage between the sensing node 525 at a high voltage level and the IDL 533 at a lower supply voltage VSS.

To overcome a voltage gap between a bit line operation bias and a sensing (or strobing) bias, the boosting up phase 704 and the boosting down phase 708 are performed respectively before and after the developing phase 706.

During the boosting up phase, as circuit diagram 610 of FIG. 6B and the boosting up phase 704 of FIG. 7 show, the boosting transistor 528 receives the boosting signal PCLK with an increasing boosting level, which charges the IDL 533 to a high voltage level along a current path 612. As the sensing voltage between the sensing node 525 and the IDL 533 remains, a voltage level of the sensing node 525 can be boosted up by a voltage increase of the IDL 533 from the lower supply voltage VSS to a sensing voltage with a high voltage level, as illustrated in FIG. 7. Note that, during the boosting up phase, the transistor 512, the transistor 514, the transistor 542, the first transistor 524 are turned off by corresponding signals.

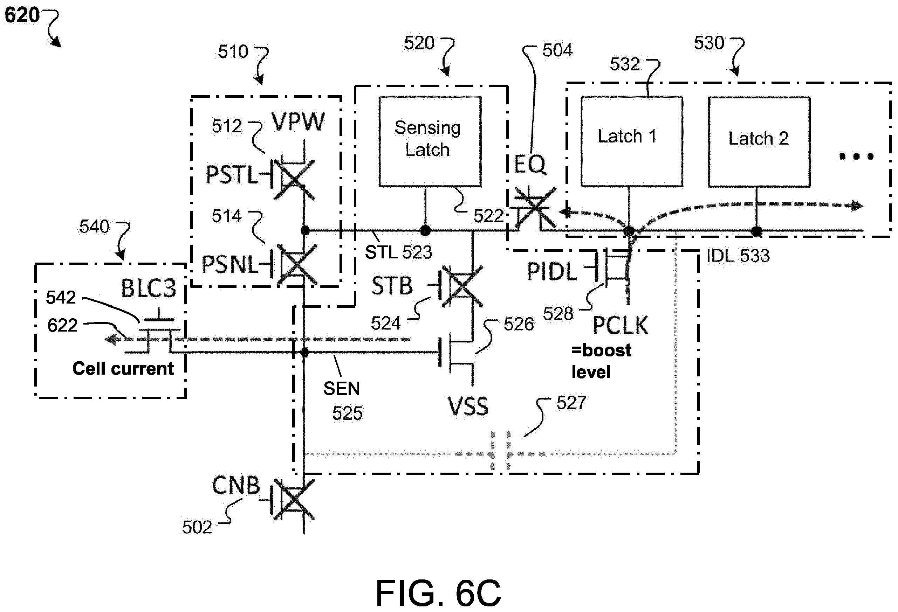

During the development phase (or a discharging phase), as circuit diagram 620 of FIG. 6C and the developing phase 706 of FIG. 7 show, the precharging circuit 510 is turned off and the sensing node 525 is no longer charged by the precharging circuit 510. Instead, the transistor 542 is turned on by receiving a control signal BLC3 (e.g., a high voltage level) at its gate terminal, and the sensing node 525 is conductively connected to the bit line. Accordingly, the sensing voltage at the sensing node 525 can be discharged by providing a sensing current (or a cell current) to the bit line via the transistor 542 (or the bit line control circuit 540) along a current path 622. When a memory cell coupled to the bit line has a high threshold voltage, e.g., high vt case as shown by curve 720 in FIG. 7, no current path is formed and the sensing voltage remains unchanged, which can correspond to a bit stored in the memory cell. When the memory cell coupled to the bit line has a low threshold voltage, e.g., low vt case as shown by curve 722 in FIG. 7, the current path 622 forms and the sensing voltage is discharged to a low voltage level corresponding to a bit stored in the memory cell. During the development phase, as shown in FIGS. 6C and 7, the boosting signal PCLK is kept at the boosting level, such that the voltage level at the sensing node 525 also changes at the boosting level.

To accurately sense the bit stored in the memory cell, the voltage level at the sensing node 525 needs to be boosted down. During the boosting down phase, e.g., as shown in circuit diagram 630 of FIG. 6D and the boosting down phase 708 of FIG. 7, the transistor 542 is turned off such that the sensing node 525 is separated from the bit line and is no longer discharged. Similarly, the precharging circuit 510 is also turned off so that the sensing node 525 is not charged by the precharging circuit 510. Instead, the boosting signal PCLK is decreased to a lower supply voltage VSS, same as the voltage level before the boosting up phase, such that a current path 632 is formed from the IDL 533 to the second terminal of the boosting transistor 528 and the voltage level at the IDL 533 is decreased. As the sensing voltage between the sensing node 525 and the IDL 533 remains, a voltage level of the sensing node 525 can be boosted down by a voltage decrease of the IDL 533, as illustrated in FIG. 7.

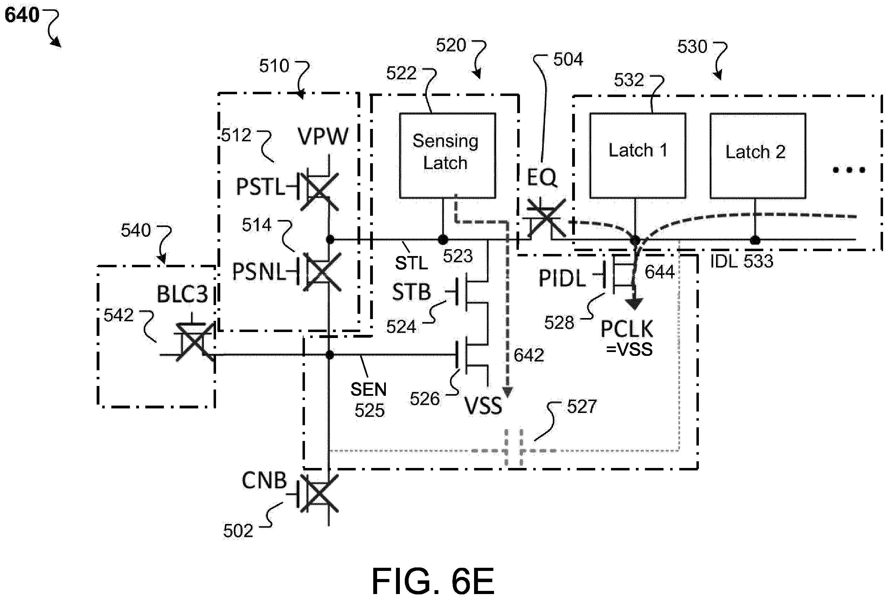

During the data strobing phase, e.g., as shown in circuit diagram 640 of FIG. 6E and the data strobing phase 710 of FIG. 7, the first transistor 524 is turned on by a strobe signal STB, and a current path 642 is formed from the sensing latch 522 to the lower supply voltage VSS at the second terminal of the second transistor 526, such that the voltage level of the sensing node 525 that corresponds to a bit stored in the memory cell can be strobed to the sensing latch 522.

For example, second n-type transistor 558a in the sensing latch 522 is coupled to the conductive line (STL) 523, and Ln node 551a in the sensing latch 522 can have a high voltage level corresponding to bit "0". If the memory cell (e.g., SLC), stores bit "0" that corresponds to a high threshold voltage, the voltage level of the sensing node 525 remains at a high voltage level after the development phase and the boosting down phase. Accordingly, the voltage level at Ln node 551a of the sensing latch 522 remains at the high voltage level, corresponding to bit "0". If the memory cell (e.g., SLC) stores bit "1" that corresponds to a low threshold voltage, the voltage level of the sensing node 525 becomes a low voltage level after the development phase and the boosting down phase. Accordingly, a voltage level at Ln node 551a of the sensing latch 522 can become a low voltage level, corresponding to bit "1".

During the data strobing phase, the precharging circuit 510 and the bit line control circuit 540 are both turned off. The IDL 533 is maintained at the lower supply voltage VSS through a current path 644. Once the voltage level of the sensing node 525 is strobed to the sensing latch 522, the first transistor 524 can be turned off by the strobe signal STB and the boosting transistor 528 can be also turned off by the control signal PIDL.

After the data strobing phase, the latch transistor 504 can be turned on by control signal EQ, such that data stored in the sensing latch 522 can be transferred to a corresponding storing latch 532 in the storing latch circuit 530 through the IDL 533. Further, as described with further details in FIGS. 8A-8B, data latched in the storing latch circuit 530 can be transferred out to a cache data latch (CDL) circuit by turning on the latch transistor 504, the transistor 514, and the connection transistor 502 in the page buffer 500.

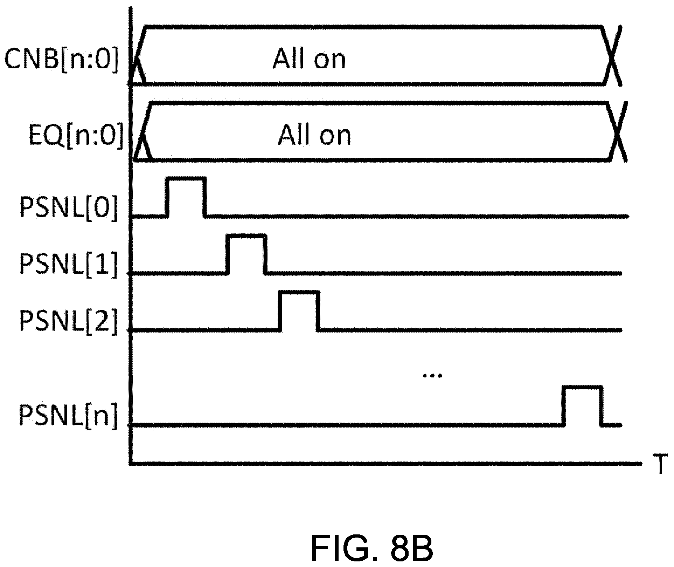

FIG. 8A illustrates an example data transfer 800 between a page buffer circuit 802 and a cache data latch (CDL) circuit 804. FIG. 8B shows a timing diagram illustrating voltage changes at different nodes of the page buffer circuit 802 during the data transfer of FIG. 8A. The page buffer circuit 802 can be the page buffer circuit 220 of FIGS. 2A-2B, the page buffer circuit 302 of FIGS. 3A-3D, the page buffer circuit 400 of FIG. 4A, or the page buffer circuit 450 of FIG. 4B. The CDL circuit 804 can be the CDL circuit 230 of FIG. 2A-2B, or the CDL circuit 304 of FIGS. 3A, 3C-3D. The page buffer circuit 802 includes a number of page buffers 810, e.g., page buffers PB_0, PB_1, ..., PB_n. Each page buffer 810 can be the page buffer 222 of FIG. 2B, the page buffer 310 of FIGS. 3A-3D, the page buffer 410 of FIG. 4A, the first page buffer 460 or the second page buffer 470 of FIG. 4B, or the page buffer 500 of FIGS. 5A-5B and FIGS. 6A-6E. Each page buffer 810 can have a same configuration. As an example, the structure of page buffer PB_0 is labelled in FIG. 8A.

Similar to FIG. 3D, in a data transfer operation, as shown in FIG. 8B, all the connection transistors 816 (e.g., the connection transistor 316 of FIG. 3D or the connection transistor 502 of FIG. 5A) are turned on by corresponding control signals CNB [n:0] such that the series of DBUS sections, e.g., data bus DBUS_0, DBUS_1, ..., DBUS_n, are conductively connected together to form an integrated DBUS (e.g., the DBUS 306 of FIG. 3D). In each page buffer 810, a latch transistor 812 (e.g., the latch transistor 504 of FIG. 5A) is turned on by a corresponding control signal EQ during the data transfer operation. To ensure data in latches of the page buffers 810 to be transferred to corresponding caches in the CDL circuit 804 through the integrated DBUS, a second transistor 814 (e.g., the transistor 514 of FIG. 5A) in each page buffer 810 is sequentially turned on by a corresponding precharging enable signal PSNL, e.g., the precharging enable signal PSNL_0, PSNL_1, ..., PSNL_n, as shown in FIG. 8B. Accordingly, a data path 801-0 for the page buffer PB_0, a data path 801-1 for the page buffer PB_1, ..., a data path 801-n for page buffer PB_n (referred to generally as data paths 801 and individually as data path 801) forms, and data in a latch of each page buffer 810 can be transferred to a corresponding cache in the CDL circuit 804. In some examples, data latched in a particular page buffer in the page buffer circuit 802 can be transferred to the CDL circuit 804 through the integrated DBUS along a data path 801 by turning on the second transistor 814 in the particular page buffer while turning off the second transistors 814 in all the other page buffers in the page buffer circuit 802.

### Example Process

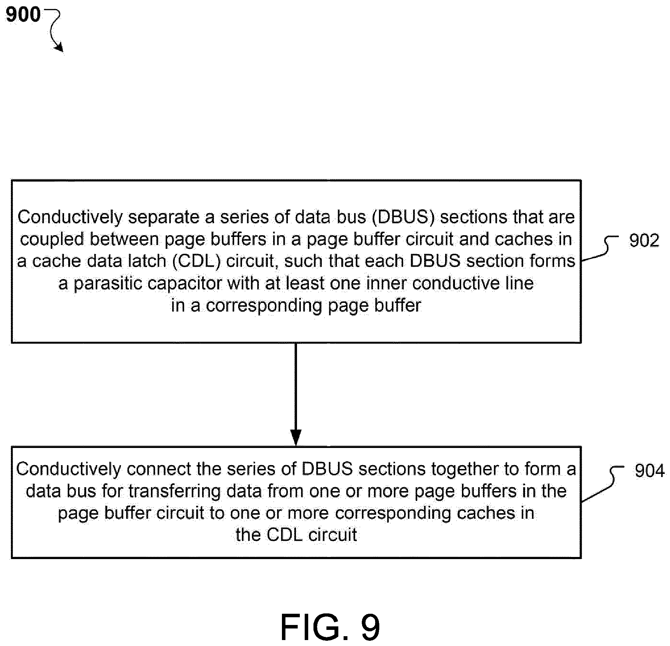

FIG. 9 illustrates an example of a process 900 for managing a page buffer circuit in a memory device, according to one or more implementations of the present disclosure. The page buffer circuit can be coupled to a cache data latch (CDL) circuit using a plurality of data bus (DBUS) sections that can be conductively connected together during a data transfer operation and can be separated from one another during a normal operation. The process 900 can be performed by the memory device.

The memory device can be the memory device 116 of FIG. 1A or the memory device 200 of FIG. 2A. The memory device can include a memory cell array (e.g., the memory cell array 210 of FIG. 2A) having a number of memory cells (e.g., memory cells 141 of FIG. 1B or memory cells 157 of FIG. 1C). The page buffer circuit can be the page buffer circuit 220 of FIGS. 2A-2B, the page buffer circuit 302 of FIGS. 3A-3D, the page buffer circuit 400 of FIG. 4A, or the page buffer circuit 450 of FIG. 4B, or the page buffer circuit 802 of FIG. 8A. The CDL circuit can be the CDL circuit 230 of FIG. 2A-2B, or the CDL circuit 304 of FIGS. 3A, 3C-3D, or the CDL circuit 804 of FIG. 8A. The CDL circuit can include a number of caches.

The page buffer circuit can include a number of page buffers. Each page buffer can be the page buffer 222 of FIG. 2B, the page buffer 310 of FIGS. 3A-3D, the page buffer 410 of FIG. 4A, the first page buffer 460 or the second page buffer 470 of FIG. 4B, the page buffer 500 of FIGS. 5A-5B and FIGS. 6A-6E, or the page buffer 810 of FIG. 8A. Each of the plurality of DBUS sections can be the DBUS section 314 of FIGS. 3A-3D or the DBUS section 420 of FIGS. 4A-4B.

In some embodiments, the memory device further includes a plurality of bit lines (e.g., the bit lines 215 of FIG. 2A-2B) coupled between the memory cell array and the page buffer circuit. Each page buffer of the plurality of page buffers can be conductively coupled to a corresponding memory cell in the memory cell array through a respective bit line of the plurality of bit lines.

At step 902, the plurality of data bus (DBUS) sections are conductively separated from one another, such that each data bus section forms a parasitic capacitor with at least one inner conductive line in a respective page buffer, e.g., for data sensing as illustrated in FIG. 3C.

In some embodiments, the memory device can perform a read operation, e.g., in response to receiving a read command from a controller such as the device controller 112 or the host controller 122 of FIG. 1A. The read command can be for reading data from the memory cell array from the page buffer circuit. The memory device can separate the plurality of DBUS sections in response to receiving the read command.

In some embodiments, each page buffer in the page buffer circuit includes a plurality of latches (e.g., storing latch 532 of FIG. 5A or the latch 550 of FIG. 5B) each conductively coupled to an inner data line (IDL) (e.g., the IDL 312 of FIGS. 3A-3D, the IDL of FIGS. 4A-4B, the IDL 533 of FIG. 5A) in the page buffer. The IDL in the page buffer is configured to form the parasitic capacitor (e.g., the parasitic capacitor 320 of FIG. 3B) with a corresponding DBUS section for the page buffer. The IDL can be positioned adjacent to and parallel to the corresponding DBUS section and conductively separated by an insulating material. Inner conductive lines in the plurality of page buffers and the plurality of DBUS sections can be formed in a layer adjacent to the memory cell array.

In some embodiments, for a page buffer in the page buffer circuit, the process 900 further includes: precharging a corresponding parasitic capacitor formed by a corresponding data bus section and a corresponding inner conductive line in the page buffer (e.g., as illustrated in FIG. 6A and FIG. 7), discharging a sensing voltage at the corresponding data bus section by conductively connecting the corresponding data bus section to a memory cell through a corresponding bit line (e.g., as illustrated in FIG. 6C and FIG. 7), and strobing a sensing result corresponding to data in the memory cell to a latch of the page buffer (e.g., as illustrated in FIG. 6E and FIG. 7).

In some embodiments, the process 900 further includes: after precharging the corresponding parasitic capacitor and before discharging the sensing voltage at the corresponding data bus section, boosting up the voltage level at the corresponding data bus section by increasing a voltage level at the corresponding inner conductive line (e.g., as illustrated in FIG. 6B and FIG. 7), and after discharging the sensing voltage at the corresponding data bus section and before strobing the sensing result, boosting down the discharged sensing voltage at the corresponding data bus section by decreasing the voltage level at the corresponding inner conductive line (e.g., as illustrated in FIG. 6D and FIG. 7).

In some embodiments, each page buffer in the page buffer circuit includes a boosting transistor (e.g., the boosting transistor 528 of FIG. 5A) having: a first terminal coupled to the IDL, a second terminal configured to receive a boosting signal (e.g., boosting signal PCLK), and a gate terminal configured to receive a control signal (e.g., control signal PIDL) to turn on or off the boosting transistor. The boosting transistor can be configured to be turned on such that a voltage level of the IDL is controlled based on a voltage level of the boosting signal (e.g., as illustrated in FIGS. 6B, 6D and FIG. 7).

At step 904, the plurality of data bus sections are conductively connected together to form a data bus for transferring data from one or more page buffers in the page buffer circuit to one or more corresponding caches in the CDL circuit. The data bus can be the data bus 240 of FIGS. 2A-2B, or the data bus 306 of FIG. 3D.

In some embodiments, the memory device performs a data transfer operation, e.g., in response to receiving a data transfer command for transferring the data from the one or more page buffers in the page buffer circuit to the one or more corresponding caches in the CDL circuit. The memory device can conductively connect the plurality of data bus sections to form the data bus in response to receiving the data transfer command.

In some embodiments, the memory device includes a plurality of connection transistors (e.g., the connection transistors 316 of FIGS. 3A, 3C-3D the second connection transistor 414 of FIG. 4A or 4B, the connection transistor 816 of FIG. 8A) coupled between adjacent DBUS sections in the plurality of DBUS sections. The plurality of connection transistors can be configured to: be turned on to conductively connect the plurality of DBUS sections together to form the data bus, and be turned off to conductively separate the plurality of DBUS sections from each other, such that each DBUS section functions as a sensing node in the respective page buffer to form the parasitic capacitor with the at least one inner conductive line in the respective page buffer.

In some embodiments, each connection transistor of the plurality of connection transistors is coupled between two adjacent DBUS sections and arranged between adjacent page buffers corresponding to the two adjacent DBUS sections.

In some embodiments, each page buffer of the plurality of page buffers includes: a respective connection transistor of the plurality of connection transistors, and a respective DBUS section of the plurality of DBUS sections. The respective connection transistor has a first terminal coupled to the respective DBUS section of the page buffer, a second terminal coupled to an adjacent DBUS section of an adjacent page buffer, and a gate terminal configured to receive a control signal (e.g., control signal CNB of FIGS. 3A, 3C-3D, FIG. 7 or FIGS. 8A-8B) for turning on or off the respective connection transistor.

In some embodiments, each page buffer of the plurality of page buffers includes: a respective DBUS section having a first sub-section and a second sub-section, and a respective second connection transistor (or section transistor) (e.g., second connection transistor 414 of FIG. 4A or 4B) coupled between the first sub-section and the second sub-section. The respective second connection transistor is configured to: be turned on to conductively connect the first sub-section and the second sub-section to form the respective DBUS section such that the plurality of DBUS sections are configured to be conductively connected together as the data bus, and be turned off to conductively separate the first sub-section and the second sub-section such that the first sub-section forms the parasitic capacitor with a corresponding inner conductive line in the page buffer.

The first sub-section can be a non-coupling-noise sub-section, and the second sub-section can be a coupling-noise sub-section. In some cases, the first sub-section of the respective DBUS section is positioned adjacent to an inner data line (IDL) in the page buffer, and the second sub-section of the respective DBUS section is positioned adjacent to a bit line through which the page buffer is coupled to the memory cell array.

In some embodiments, the plurality of page buffers comprise first and second page buffers sequentially arranged in the page buffer circuit, and a second sub-section of the first page buffer is coupled to a first sub-section of the second page buffer by a corresponding connection transistor of the plurality of connection transistors, e.g., as illustrated in FIG. 4A.

In some embodiments, the plurality of page buffers include first, second, and third page buffers arranged in order in the page buffer circuit, and second sub-sections of the first and second page buffers are conductively connected, and first sub-sections of the second and third page buffers are coupled through a corresponding connection transistor of the plurality of connection transistors, e.g., as illustrated in FIG. 4B. Each of the first and third page buffers can include no connection transistor, and the second page buffer can include the corresponding connection transistor. In some embodiments, the plurality of page buffers include multiple pairs of first and second page buffers arranged in order in the page buffer circuit, and second sub-sections of the first and second page buffers are conductively connected, and first sub-sections of the first and second page buffers are respectively coupled to first sub-sections of adjacent page buffers in adjacent pairs through corresponding connection transistors of the plurality of connection transistors.

In some embodiments, each page buffer of the plurality of page buffers further includes a respective second transistor (e.g., the transistor 514 of FIGS. 5A, 6A-6E, or the second transistor 814 of FIG. 8A). The respective second transistor has: a first terminal coupled to one or more latches in the page buffer through the at least one inner conductive line, a second terminal coupled to the respective DBUS section, and a gate terminal coupled to receive a second control signal (e.g., precharging enable signal PSNL of FIG. 7 or FIG. 8B) for turning on or off the respective second transistor. The respective second transistor can be configured to be turned on to couple the respective DBUS section to a supply voltage for precharging the parasitic capacitor of the page buffer while the plurality of connection transistors are turned off to conductively separate the plurality of DBUS sections, e.g., as illustrated in FIGS. 6A and 7. The process 900 can further include: turning on the particular transistor in the page buffer and turning off particular transistors in other page buffers in the page buffer circuit to transfer data latched in the page buffer to a corresponding cache in the CDL circuit through the data. The process 900 can include: sequentially turning on a corresponding particular transistor in each of the page buffers in the page buffer circuit to transfer data latched in the page buffer to a corresponding cache in the CDL circuit through the data bus, e.g., as illustrated in FIG. 8B).

In some embodiments, each page buffer in the page buffer circuit includes: a sensing latch (e.g., the sensing latch 522 of FIG. 5A) coupled to the memory cell array, and a latch transistor (e.g., the transistor 504 of FIG. 5A or the latch transistor 812 of FIG. 8A) coupled between the sensing latch and the IDL and configured to be turned on to conductively connect the sensing latch to the IDL or be turned off to separate the sensing latch from the IDL.

The disclosed and other examples can be implemented as one or more computer program products, for example, one or more modules of computer program instructions encoded on a computer readable medium for execution by, or to control the operation of, data processing apparatus. The computer readable medium can be a machine-readable storage device, a machine-readable storage substrate, a memory device, or a combination of one or more them. The term "data processing apparatus" encompasses all apparatus, devices, and machines for processing data, including by way of example a programmable processor, a computer, or multiple processors or computers. The apparatus can include, in addition to hardware, code that creates an execution environment for the computer program in question, e.g., code that constitutes processor firmware, a protocol stack, a database management system, an operating system, or a combination of one or more of them.

A system may encompass all apparatus, devices, and machines for processing data, including by way of example a programmable processor, a computer, or multiple processors or computers. A system can include, in addition to hardware, code that creates an execution environment for the computer program in question, e.g., code that constitutes processor firmware, a protocol stack, a database management system, an operating system, or a combination of one or more of them.

A computer program (also known as a program, software, software application, script, or code) can be written in any form of programming language, including compiled or interpreted languages, and it can be deployed in any form, including as a standalone program or as a module, component, subroutine, or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program can be deployed for execution on one computer or on multiple computers that are located at one site or distributed across multiple sites and interconnected by a communications network.

The processes and logic flows described in this document can be performed by one or more programmable processors executing one or more computer programs to perform the functions described herein. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both. The essential elements of a computer can include a processor for performing instructions and one or more memory devices for storing instructions and data. Generally, a computer can also include, or be operatively coupled to receive data from or transfer data to, or both, one or more mass storage devices for storing data, e.g., magnetic, magneto optical disks, or optical disks. However, a computer need not have such devices. Computer readable media suitable for storing computer program instructions and data can include all forms of nonvolatile memory, media and memory devices, including by way of example semiconductor memory devices, e.g., EPROM, EEPROM, and flash memory devices; magnetic disks. The processor and the memory can be supplemented by, or incorporated in, special purpose logic circuitry.

While this document may describe many specifics, these should not be construed as limitations on the scope of an invention that is claimed or of what may be claimed, but rather as descriptions of features specific to particular embodiments. Certain features that are described in this document in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination in some cases can be excised from the combination, and the claimed combination may be directed to a sub-combination or a variation of a sub-combination. Similarly, while operations are depicted in the drawings in a particular order, this should not be understood as requiring that such operations be performed in the particular order shown or in sequential order, or that all illustrated operations be performed, to achieve desirable results.

Only a few examples and implementations are disclosed. Variations, modifications, and enhancements to the described examples and implementations and other implementations can be made based on what is disclosed.

## Claims

1. A page buffer circuit (220, 302, 400, 450, 802), wherein the page buffer circuit (220, 302, 400, 450, 802) comprises:
a plurality of page buffers (310); and
a plurality of data bus, DBUS, sections (420),
wherein the plurality of DBUS sections (420) is configured to be conductively connected together as a data bus (305), and
wherein each DBUS section (420) in the plurality of DBUS sections (420) corresponds to a page buffer (310) of the plurality of page buffers (310), and is configured to conductively separate from at least one adjacent DBUS section (420),
wherein each page buffer (410, 460, 470) of the plurality of page buffers (310) comprises:
a DBUS section (420) having a non-coupling noise DBUS sub-section (420a) and a coupling noise DBUS sub-section (420b), and
wherein the non-coupling noise DBUS sub-section (420a) is arranged adjacent to an inner metal line, IDL, to form a parasitic capacitor, and the coupling noise DBUS sub-section (420b) is arranged adjacent to a bit line,
a section transistor (414) coupled between the non-coupling noise DBUS sub-section (420a) and the coupling noise DBUS sub-section (420b), and
wherein the section transistor (414) is configured to:
during a data transfer operation, be turned on such that the non-coupling noise DBUS sub-section (420a) and the coupling noise DBUS sub-section (420b) are conductively connected to form the DBUS section (420) for data transfer, and
during a normal operation, be turned off such that the non-coupling noise DBUS sub-section (420a) is used as a sensing node to form the parasitic capacitor (320, 527) for data sensing, while the coupling noise DBUS sub-section (420b) is not used.

2. The page buffer circuit (220, 302, 400, 450, 802) of claim 1, comprising a plurality of connection transistors (316) coupled between adjacent DBUS sections in the plurality of DBUS sections (420),
wherein the plurality of connection transistors (316) is configured to:
be turned on to conductively connect the plurality of DBUS sections (420) together to form the data bus, and
be turned off to conductively separate the plurality of DBUS sections (420) from each other.

3. The page buffer circuit (220, 302, 400, 450, 802) of claim 2, wherein each page buffer (410, 460, 470) of the plurality of page buffers (310) comprises:
a DBUS section,
a first transistor configured to be a connection transistor corresponding to the page buffer, and
a second transistor having: a first terminal coupled to one or more latches in the page buffer through the at least one inner conductive line, a second terminal coupled to the DBUS section, and a gate terminal coupled to receive a second control signal for turning on or off the second transistor,
wherein the plurality of connection transistors (316) is configured to be turned on to conductively connect the plurality of DBUS sections (420) to form the data bus, and a particular second transistor of a particular page buffer in the plurality of page buffers is configured to be turned on and second transistors of other page buffers of the plurality of page buffers are configured to be turned off, such that data latched in the particular page buffer is transferred from the particular page buffer to a corresponding cache in a cache data latch, CDL, circuit (230, 304) through the data bus.

4. The page buffer circuit (220, 302, 400, 450, 802) of anyone of the claims 1 to 3, wherein each page buffer of the plurality of page buffers comprises:
a plurality of latches (532, 550) each conductively coupled to the IDL in the page buffer, wherein the IDL in the page buffer is configured to form the parasitic capacitor (320, 527) with a corresponding DBUS section for the page buffer,
a sensing latch (522),
a latch transistor coupled between the sensing latch (522) and the IDL and configured to be turned on to conductively connect the sensing latch (522) to the IDL or be turned off to separate the sensing latch (522) from the IDL, and
a boosting transistor having: a first terminal coupled to the IDL, a second terminal configured to receive a boosting signal, and a gate terminal configured to receive a control signal to turn on or off the boosting transistor, and
wherein the boosting transistor is configured to be turned on such that a voltage level of the IDL is associated with a voltage level of the boosting signal.

5. A memory device (200), wherein the memory device (220) comprises:
a memory cell array (210) comprising memory cells;
the page buffer circuit (220, 302, 400, 450, 802) of anyone of the claims 1 to 4; and
a cache data latch, CDL, circuit (230, 304) comprising a plurality of caches coupled to the plurality of page buffers (310) in the page buffer circuit (220, 302, 400, 450, 802) through the plurality of data bus (DBUS) sections (420),
wherein the plurality of DBUS sections (420) is configured to be conductively connected together as a data bus (305) for data transfer, and
wherein each DBUS section (420) of the plurality of DBUS sections (420) corresponds to the page buffer (310) of the plurality of page buffers (310) and is configured to conductively separate from at least one adjacent DBUS section (420) for data sensing in the memory cell array (210).

6. The memory device (220) of claim 5, wherein each page buffer of the plurality of page buffers comprises:
a first transistor configured to be a connection transistor corresponding to the page buffer, and
a DBUS section, and
wherein the first transistor has a first terminal coupled to the DBUS section of the page buffer, a second terminal coupled to an adjacent DBUS section of an adjacent page buffer, and a gate terminal configured to receive a control signal for turning on or off the first transistor.

7. The memory device (220) of claim 6, wherein each page buffer of the plurality of page buffers further comprises a second transistor having: a first terminal coupled to one or more latches in the page buffer through the at least one inner conductive line, a second terminal coupled to the DBUS section, and a gate terminal coupled to receive a second control signal for turning on or off the second transistor, and
wherein the memory device (220) is configured to:
turn on the plurality of connection transistors (316) to conductively connect the plurality of DBUS sections (420) to form the data bus, and
turn on a respective second transistor of a particular page buffer of the plurality of page buffers and turn off second transistors in other page buffers of the plurality of page buffers, such that data latched in the particular page buffer is transferred from the particular page buffer to a corresponding cache in the CDL circuit through the data bus;
wherein the DBUS section is configured to conductively separate from the adjacent DBUS section and to form a parasitic capacitor (320, 527) with at least one internal conductive line of the page buffer, and
wherein the second transistor is configured to be turned on to couple the DBUS section to a supply voltage for precharging the parasitic capacitor (320, 527) while the plurality of connection transistors (316) is turned off to conductively separate the plurality of DBUS sections (420).

8. The memory device (220) of claim 5, wherein the plurality of page buffers comprises a first buffer (460) and a second page buffer (470) sequentially arranged in the page buffer circuit (220, 302, 400, 450, 802), and
wherein a second sub-section of the first page buffer (460) is coupled to a first sub-section of the second page buffer (470) by a corresponding connection transistor of the plurality of connection transistors (316).

9. The memory device (220) of claim 5, wherein the plurality of page buffers comprises a first buffer (460), a second buffer (470) and a third page buffer arranged in order in the page buffer circuit (220, 302, 400, 450, 802), and
wherein second sub-sections of the first page buffer (460) and the second page buffer (470) are conductively connected, and first sub-sections of the second buffer (470) and the third page buffer are coupled through a corresponding connection transistor of the plurality of connection transistors (316).

10. The memory device (220) of claim 5, wherein each page buffer in the page buffer circuit (220, 302, 400, 450, 802) comprises a plurality of latches (532, 550) each conductively coupled to the IDL in the page buffer, and
wherein the IDL in the page buffer is configured to form the parasitic capacitor (320) with a corresponding DBUS section for the page buffer.

11. The memory device (220) of claim 10, wherein each page buffer in the page buffer circuit (220, 302, 400, 450, 802) comprises:
a sensing latch (522) coupled to the memory cell array, and
a latch transistor coupled between the sensing latch (522) and the IDL and configured to be turned on to conductively connect the sensing latch (522) to the IDL or be turned off to separate the sensing latch (522) from the IDL.

12. The memory device (220) of claim 10, wherein each page buffer in the page buffer circuit (220, 302, 400, 450, 802) comprises a boosting transistor having: a first terminal coupled to the IDL, a second terminal configured to receive a boosting signal, and a gate terminal configured to receive a control signal to turn on or off the boosting transistor, and
wherein the boosting transistor is configured to be turned on such that a voltage level of the IDL is controlled based on a voltage level of the boosting signal.

13. An integrated circuit (300), wherein the integrated circuit (300) comprises:
a first circuit comprising a page buffer circuit (310) according to claim 1 compprising a plurality of page buffers (PB0, PB1,....); and
a second circuit coupled to the first circuit through a plurality of conductive sections (316-0, 316-1, 316-n), and comprising a cache data latch, CDL, circuit (230, 304) comprising a plurality of caches;
wherein the plurality of conductive sections (316-0, 316-1, 316-n) is configured to be conductively connected together as a conductive bus (305) between the first circuit and the second circuit, and
wherein each conductive section (316-0, 316-1, 316-n) in the plurality of conductive sections (316-0, 316-1, 316-n) corresponds to a page buffer circuit (310) in the first circuit, and is configured to conductively separate from at least one adjacent conductive section (316-0, 316-1, 316-n). wherein the integrated circuit (300) is configured to transfer data from a page buffer in the page buffer circuit (220, 302, 400, 450, 802) to a corresponding cache in the CDL circuit through the conductive bus,
wherein each conductive section (316-0, 316-1, 316-n) of the plurality of conductive sections (310) comprises:
a DBUS section (420) having a non-coupling noise DBUS sub-section (420a) and a coupling noise DBUS sub-section (420b), and
a section transistor (414) coupled between the non-coupling noise DBUS sub-section (420a) and the coupling noise DBUS sub-section (420b), and
wherein the non-coupling noise DBUS sub-section (420a) is arranged adjacent to an inner metal line, IDL, to form a parasitic capacitor, and the coupling noise DBUS sub-section (420b) is arranged adjacent to a bit line,
wherein the section transistor (414) is configured to:
during a data transfer operation, be turned on such that the non-coupling noise DBUS sub-section (420a) and the coupling noise DBUS sub-section (420b) are conductively connected to form the DBUS section (420) for data transfer, and
during a normal operation, be turned off such that the non-coupling noise DBUS sub-section (420a) is used as a sensing node to form a parasitic capacitor (320) for data sensing, while the coupling noise DBUS sub-section (420b) is not used.

## Patentansprüche

1. Seitenpufferschaltung (220, 302, 400, 450, 802), wobei die Seitenpufferschaltung (220, 302, 400, 450, 802) aufweist:
eine Vielzahl an Seitenpuffern (310), und
eine Vielzahl an Datenbus-Abschnitten, DBUS, (420),
wobei die Vielzahl der DBUS-Abschnitte (420) so ausgestaltet ist, dass sie als ein Datenbus (305) leitend miteinander verbunden sind, und
wobei jeder DBUS-Abschnitt (420) in der Vielzahl der DBUS-Abschnitte (420) einem Seitenpuffer (310) der Vielzahl der Seitenpuffer (310) entspricht und so ausgestaltet ist, dass er von mindestens einem benachbarten DBUS-Abschnitt (420) leitend getrennt ist,
wobei jeder Seitenpuffer (410, 460, 470) der Vielzahl der Seitenpuffer (310) aufweist:
einen DBUS-Abschnitt (420), der einen DBUS-Unterabschnitt (420a) ohne Verbindungsrauschen und einen DBUS-Unterabschnitt (420b) mit Verbindungsrauschen aufweist, und
wobei der DBUS-Unterabschnitt (420a) ohne Verbindungsrauschen benachbart zu einer inneren Metallleitung, IDL, angeordnet ist, um einen parasitären Kondensator zu bilden, und der DBUS-Unterabschnitt (420b) mit Verbindungsrauschen benachbart zu einer Bitleitung angeordnet ist,
einen Abschnittstransistor (414), der zwischen dem DBUS-Teilabschnitt (420a) ohne Verbindungsrauschen und dem DBUS-Teilabschnitt (420b) mit Verbindungsrauschen geschaltet ist, und
wobei der Abschnittstransistor (414) ausgestaltet ist, um
während eines Datenübertragungsvorgangs so eingeschaltet zu werden, dass der DBUS-Teilabschnitt (420a) ohne Verbindungsrauschen und der DBUS-Teilabschnitt (420b) mit Verbindungsrauschen leitend verbunden sind, um den DBUS-Abschnitt (420) für die Datenübertragung zu bilden, und
während eines normalen Betriebs so ausgeschaltet zu werden, dass der DBUS-Teilabschnitt (420a) ohne Verbindungsrauschen als ein Erfassungsknoten verwendet wird, um den parasitären Kondensator (320, 527) zur Datenerfassung zu bilden, während der DBUS-Teilabschnitt (420b) mit Verbindungsrauschen nicht verwendet wird.

2. Seitenpufferschaltung (220, 302, 400, 450, 802) nach Anspruch 1, welche eine Vielzahl an Verbindungstransistoren (316) aufweist, die zwischen benachbarten DBUS-Abschnitten in der Vielzahl von DBUS-Abschnitten (420) geschaltet sind,
wobei die Vielzahl von Verbindungstransistoren (316) ausgestaltet ist, um
eingeschaltet zu werden, um die Vielzahl der DBUS-Abschnitte (420) miteinander leitend zu verbinden und so den Datenbus zu bilden, und
ausgeschaltet zu werden, um die Vielzahl der DBUS-Abschnitte (420) voneinander leitend zu trennen.

3. Seitenpufferschaltung (220, 302, 400, 450, 802) nach Anspruch 2, wobei jeder Seitenpuffer (410, 460, 470) der Vielzahl der Seitenpuffer (310) aufweist:
einen DBUS-Abschnitt,
einen ersten Transistor, der als ein dem Seitenpuffer zugeordneter Verbindungstransistor ausgestaltet ist, und
einen zweiten Transistor, der einen ersten Anschluss, der über die mindestens eine innere leitende Leitung mit einem oder mehreren Latches in dem Seitenpuffer verbunden ist, einen zweiten Anschluss, der mit dem DBUS-Abschnitt verbunden ist, und einen Gatter-Anschluss aufweist, der so geschaltet ist, dass er ein zweites Steuersignal zum Ein- oder Ausschalten des zweiten Transistors empfängt,
wobei die Vielzahl der Verbindungstransistoren (316) so ausgestaltet ist, dass sie eingeschaltet werden, um die Vielzahl der DBUS-Abschnitte (420) leitend zu verbinden und so den Datenbus zu bilden, und ein bestimmter zweiter Transistor eines bestimmten Seitenpuffers aus der Vielzahl der Seitenpuffer so ausgestaltet ist, dass er eingeschaltet wird, während zweite Transistoren anderer Seitenpuffer aus der Vielzahl der Seitenpuffer so ausgestaltet sind, dass sie so ausgeschaltet werden, dass in dem bestimmten Seitenpuffer zwischengespeicherte Daten über den Datenbus von dem bestimmten Seitenpuffer an einen entsprechenden Cache in einer Cache-Daten-Latch-Schaltung, CDL, (230, 304) übertragen werden.

4. Seitenpufferschaltung (220, 302, 400, 450, 802) nach einem der Ansprüche 1 bis 3, wobei jeder Seitenpuffer der Vielzahl der Seitenpuffer aufweist:
eine Vielzahl an Latches (532, 550), die jeweils leitend mit dem IDL in dem Seitenpuffer verbunden sind, wobei der IDL in dem Seitenpuffer so ausgestaltet ist, dass er den parasitären Kondensator (320, 527) mit einem entsprechenden DBUS-Abschnitt für den Seitenpuffer bildet,
ein Abtast-Latch (522),
einen Latch-Transistor, der zwischen dem Abtast-Latch (522) und dem IDL geschaltet und so ausgestaltet ist, dass er eingeschaltet wird, um den Abtast-Latch (522) leitend mit dem IDL zu verbinden, oder ausgeschaltet wird, um den Abtast-Latch (522) von dem IDL zu trennen, und
einen Boost-Transistor, der einen ersten Anschluss, der mit der IDL verbunden ist, einen zweiten Anschluss, der so ausgestaltet ist, dass er ein Boost-Signal empfängt, und einen Gatter-Anschluss aufweist, der so ausgestaltet ist, dass er ein Steuersignal zum Ein- oder Ausschalten des Boost-Transistors empfängt, und
wobei der Boost-Transistor so ausgestaltet ist, dass er so eingeschaltet wird, dass ein Spannungspegel der IDL mit einem Spannungspegel des Boost-Signals in Beziehung steht.

5. Speichervorrichtung (200), wobei die Speichervorrichtung (220) aufweist:
eine Speicherzellenanordnung (210) mit Speicherzellen,
die Seitenpufferschaltung (220, 302, 400, 450, 802) nach einem der Ansprüche 1 bis 4, und
eine Cache-Daten-Latch-Schaltung, CDL-Schaltung, (230, 304), die eine Vielzahl an Caches aufweist, die mit der Vielzahl der Seitenpuffer (310) in der Seitenpufferschaltung (220, 302, 400, 450, 802) über die Vielzahl der Datenbusabschnitte, DBUS-Abschnitte, (420) verbunden sind,
wobei die Vielzahl der DBUS-Abschnitte (420) so ausgestaltet ist, dass sie zur Datenübertragung als ein Datenbus (305) leitend miteinander verbunden sind, und
wobei jeder DBUS-Abschnitt (420) der Vielzahl der DBUS-Abschnitte (420) dem Seitenpuffer (310) der Vielzahl der Seitenpuffer (310) entspricht und so ausgestaltet ist, dass er zur Datenerfassung in der Speicherzellenanordnung (210) leitend von mindestens einem benachbarten DBUS-Abschnitt (420) getrennt ist.

6. Speichervorrichtung (220) nach Anspruch 5, wobei jeder Seitenpuffer der Vielzahl der Seitenpuffer aufweist:
einen ersten Transistor, der als ein Verbindungstransistor ausgestaltet ist, der dem Seitenpuffer entspricht, und
einen DBUS-Abschnitt, und
wobei der erste Transistor einen ersten Anschluss, der mit dem DBUS-Abschnitt des Seitenpuffers verbunden ist, einen zweiten Anschluss, der mit einem benachbarten DBUS-Abschnitt eines benachbarten Seitenpuffers verbunden ist, und einen Gatter-Anschluss aufweist, der so ausgestaltet ist, dass er ein Steuersignal zum Ein- oder Ausschalten des ersten Transistors empfängt.

7. Speichervorrichtung (220) nach Anspruch 6, wobei jeder Seitenpuffer der Vielzahl der Seitenpuffer ferner einen zweiten Transistor aufweist, der einen ersten Anschluss, der über die mindestens eine innere leitende Leitung mit einem oder mehreren Latches in dem Seitenpuffer verbunden ist, einen zweiten Anschluss, der mit dem DBUS-Abschnitt verbunden ist, und einen Gatter-Anschluss aufweist, der so ausgestaltet ist, dass er ein zweites Steuersignal zum Ein- oder Ausschalten des zweiten Transistors empfängt, und
wobei die Speichervorrichtung (220) ausgestaltet ist, um
die Vielzahl der Verbindungstransistoren (316) einzuschalten, um die Vielzahl der DBUS-Abschnitte (420) leitend zu verbinden und so den Datenbus zu bilden, und
einen jeweiligen zweiten Transistor eines bestimmten Seitenpuffers der Vielzahl der Seitenpuffer so einzuschalten und zweite Transistoren in anderen Seitenpuffern der Vielzahl der Seitenpuffer so auszuschalten, dass in dem bestimmten Seitenpuffer zwischengespeicherte Daten von dem bestimmten Seitenpuffer über den Datenbus an einen entsprechenden Cache in der CDL-Schaltung übertragen werden,
wobei der DBUS-Abschnitt ausgestaltet ist, um sich leitend von dem benachbarten DBUS-Abschnitt zu trennen und einen parasitären Kondensator (320, 527) mit mindestens einer internen leitenden Leitung des Seitenpuffers zu bilden, und
wobei der zweite Transistor so ausgestaltet ist, dass er eingeschaltet wird, um den DBUS-Abschnitt an eine Versorgungsspannung zum Vorladen des parasitären Kondensators (320, 527) zu verbinden, während die Vielzahl der Verbindungstransistoren (316) ausgeschaltet ist, um die Vielzahl der DBUS-Abschnitte (420) leitend zu trennen.

8. Speichervorrichtung (220) nach Anspruch 5, wobei die Vielzahl der Seitenpuffer einen ersten Puffer (460) und einen zweiten Seitenpuffer (470) aufweist, die in der Seitenpufferschaltung (220, 302, 400, 450, 802) in Reihe angeordnet sind, und
wobei ein zweiter Teilabschnitt des ersten Seitenpuffers (460) über einen entsprechenden Verbindungstransistor der Vielzahl der Verbindungstransistoren (316) mit einem ersten Teilabschnitt des zweiten Seitenpuffers (470) verbunden ist.

9. Speichervorrichtung (220) nach Anspruch 5, wobei die Vielzahl der Seitenpuffer einen ersten Puffer (460), einen zweiten Puffer (470) und einen dritten Seitenpuffer aufweist, die der Reihe nach in der Seitenpufferschaltung (220, 302, 400, 450, 802) angeordnet sind, und
wobei zweite Teilabschnitte des ersten Seitenpuffers (460) und des zweiten Seitenpuffers (470) leitend verbunden sind und erste Teilabschnitte des zweiten Seitenpuffers (470) und des dritten Seitenpuffers über einen entsprechenden Verbindungstransistor der Vielzahl der Verbindungstransistoren (316) verbunden sind.

10. Speichervorrichtung (220) nach Anspruch 5, wobei jeder Seitenpuffer in der Seitenpufferschaltung (220, 302, 400, 450, 802) eine Vielzahl an Latches (532, 550) aufweist, die jeweils leitend mit dem IDL in dem Seitenpuffer verbunden sind, und
wobei der IDL in dem Seitenpuffer so ausgestaltet ist, dass er den parasitären Kondensator (320) mit einem entsprechenden DBUS-Abschnitt für den Seitenpuffer bildet.

11. Speichervorrichtung (220) nach Anspruch 10, wobei jeder Seitenpuffer in der Seitenpufferschaltung (220, 302, 400, 450, 802) aufweist:
einen mit der Speicherzellenanordnung verbundenen Abtast-Latch (522) und
einen zwischen dem Abtast-Latch (522) und dem IDL geschalteten Latch-Transistor, der so ausgestaltet ist, dass er eingeschaltet wird, um den Abtast-Latch (522) leitend mit dem IDL zu verbinden, oder ausgeschaltet wird, um den Abtast-Latch (522) von dem IDL zu trennen.

12. Speichervorrichtung (220) nach Anspruch 10, wobei jeder Seitenpuffer in der Seitenpufferschaltung (220, 302, 400, 450, 802) einen Boost-Transistor aufweist, der einen ersten Anschluss, der mit der IDL verbunden ist, einen zweiten Anschluss, der ausgestaltet ist, um ein Boost-Signal zu empfangen, und einen Gatter-Anschluss aufweist, der so ausgestaltet ist, dass er ein Steuersignal empfängt, um den Boost-Transistor einzuschalten oder auszuschalten, und
wobei der Boost-Transistor ausgestaltet ist, um so eingeschaltet zu werden, dass ein Spannungspegel der IDL auf der Grundlage eines Spannungspegels des Boost-Signals gesteuert wird.

13. Integrierte Schaltung (300), wobei die integrierte Schaltung (300) aufweist:
eine erste Schaltung, die eine Seitenpufferschaltung (310) nach Anspruch 1 aufweist, die eine Vielzahl an Teilschaltungen (310), eine Vielzahl an Seitenpuffern (PB0, PB1, ...) aufweist, und
eine zweite Schaltung, die über eine Vielzahl an leitenden Abschnitten (316-0, 316-1, 316-n) mit der ersten Schaltung verbunden ist und eine Cache-Daten-Latch-Schaltung, CDL-Schaltung, (230, 304) aufweist, die eine Vielzahl an Caches aufweist,
wobei die Vielzahl der leitenden Abschnitte (316-0, 316-1, 316-n) so ausgestaltet ist, dass sie als ein leitender Bus (305) zwischen der ersten Schaltung und der zweiten Schaltung leitend miteinander verbunden sind, und
wobei jeder leitende Abschnitt (316-0, 316-1, 316-n) in der Vielzahl der leitenden Abschnitte (316-0, 316-1, 316-n) einer Seitenpufferschaltung (310) in der ersten Schaltung entspricht und so ausgestaltet ist, dass er von mindestens einem benachbarten leitfähigen Abschnitt (316-0, 316-1, 316-n) leitend getrennt ist, wobei die integrierte Schaltung (300) so ausgestaltet ist, dass sie Daten von einem Seitenpuffer in der Seitenpufferschaltung (220, 302, 400, 450, 802) über den leitenden Bus an einen entsprechenden Cache in der CDL-Schaltung überträgt,
wobei jeder leitende Abschnitt (316-0, 316-1, 316-n) der Vielzahl der leitenden Abschnitte (310) aufweist:
einen DBUS-Abschnitt (420), der einen DBUS-Teilabschnitt (420a) ohne Verbindungsrauschen und einen DBUS-Teilabschnitt mit Verbindungsrauschen (420b) aufweist, sowie
einen Abschnittstransistor (414), der zwischen dem DBUS-Teilabschnitt (420a) ohne Verbindungsrauschen und dem DBUS-Teilabschnitt (420b) mit Verbindungsrauschen geschaltet ist, und
wobei der DBUS-Teilabschnitt (420a) ohne Verbindungsrauschen benachbart zu einer inneren Metallleitung, IDL, angeordnet ist, um einen parasitären Kondensator zu bilden, und der DBUS-Teilabschnitt (420b) mit Verbindungsrauschen benachbart zu einer Bitleitung angeordnet ist,
wobei der Abschnittstransistor (414) ausgestaltet ist, um
während eines Datenübertragungsvorgangs so eingeschaltet zu werden, dass der DBUS-Teilabschnitt (420a) ohne Verbindungsrauschen und der DBUS-Teilabschnitt (420b) mit Verbindungsrauschen leitend verbunden sind, um den DBUS-Abschnitt (420) für die Datenübertragung zu bilden, und
während eines normalen Betriebs so ausgeschaltet zu werden, dass der DBUS-Teilabschnitt (420a) ohne Verbindungsrauschen als ein Abtastknoten verwendet wird, um einen parasitären Kondensator (320) für die Datenabtastung zu bilden, während der DBUS-Teilabschnitt (420b) mit Verbindungsrauschen nicht verwendet wird.

## Revendications

1. Circuit tampon de page (220, 302, 400, 450, 802), le circuit tampon de page (220, 302, 400, 450, 802) comprenant :
une pluralité de tampons de page (310) ; et
une pluralité de segments de bus de données, DBUS, (420),
dans lequel la pluralité de segments de DBUS (420) sont configurés pour être connectés ensemble par conductibilité en tant que bus de données (305), et
dans lequel chaque segment de DBUS (420) de la pluralité de segments de DBUS (420) correspond à un tampon de page (310) de la pluralité de tampons de page (310), et est configuré pour se séparer sur le plan de la conductibilité d'au moins un segment de DBUS adjacent (420),
dans lequel chaque tampon de page (410, 460, 470) de la pluralité de tampons de page (310) comprend :
un segment de DBUS (420) ayant un sous-segment de DBUS sans bruit de couplage (420a) et un sous-segment de DBUS à bruit de couplage (420b), et
dans lequel le sous-segment de DBUS sans bruit de couplage (420a) est adjacent à une ligne métallique interne, IDL, afin de former un condensateur parasite, et le sous-segment de DBUS à bruit de couplage (420b) est adjacent à une ligne de bits,
un transistor de segment (414) couplé entre le sous-segment de DBUS sans bruit de couplage (420a) et le sous-segment de DBUS à bruit de couplage (420b), et
dans lequel le transistor de segment (414) est configuré pour :
pendant une opération de transfert de données, être activé de sorte que le sous-segment de DBUS sans bruit de couplage (420a) et le sous-segment de DBUS à bruit de couplage (420b) sont connectés par conductibilité afin de former le segment de DBUS (420) pour le transfert de données, et
pendant un fonctionnement normal, être désactivé de sorte que le sous-segment de DBUS sans bruit de couplage (420a) est utilisé en tant que nœud capteur afin de former le condensateur parasite (320, 527) pour la détection de données, tandis que le sous-segment de DBUS à bruit de couplage (420b) n'est pas utilisé.

2. Circuit tampon de page (220, 302, 400, 450, 802) selon la revendication 1, comprenant une pluralité de transistors de connexion (316) couplés entre des segments de DBUS adjacents de la pluralité de segments de DBUS (420),
dans lequel la pluralité de transistors de connexion (316) est configurée pour :
être activée pour connecter ensemble par conductibilité les segments de DBUS de la pluralité de segments de DBUS (420) afin de former le bus de données, et
être désactivée pour séparer les uns des autres sur le plan de la conductibilité les segments de DBUS de la pluralité de segments de DBUS (420).

3. Circuit tampon de page (220, 302, 400, 450, 802) selon la revendication 2, dans lequel chaque tampon de page (410, 460, 470) de la pluralité de tampons de page (310) comprend :
un segment de DBUS,
un premier transistor configuré pour être un transistor de connexion correspondant au tampon de page, et
un deuxième transistor ayant : une première borne couplée à un ou plusieurs verrous dans le tampon de page par l'intermédiaire de l'au moins une ligne conductrice interne, une deuxième borne couplée au segment de DBUS, et une borne de grille couplée pour recevoir un deuxième signal de commande pour activer ou désactiver le deuxième transistor,
dans lequel la pluralité de transistors de connexion (316) sont configurés pour être activés afin de connecter par conductibilité la pluralité de segments de DBUS (420) pour former le bus de données, et un deuxième transistor spécifique d'un tampon de page donné parmi la pluralité de tampons de page est configuré pour être activé et des deuxièmes transistors d'autres tampons de page de la pluralité de tampons de page sont configurés pour être désactivés, de sorte que des données verrouillées dans le tampon de page spécifique sont transférées du tampon de page spécifique à un cache correspondant dans un circuit à verrouillage de données d'antémémoire, CDL, (230, 304) par l'intermédiaire du bus de données.

4. Circuit tampon de page (220, 302, 400, 450, 802) selon l'une quelconque des revendications 1 à 3, dans lequel chaque tampon de page de la pluralité de tampons de page comprend :
une pluralité de verrous (532, 550), chacun couplé par conductibilité à l'IDL dans le tampon de page, dans lequel l'IDL dans le tampon de page est configurée pour former le condensateur parasite (320, 527) avec un segment de DBUS correspondant pour le tampon de page,
un verrou de détection (522),
un transistor de verrouillage couplé entre le verrou de détection (522) et l'IDL et configuré pour être activé afin de connecter par conductibilité le verrou de détection (522) à l'IDL ou pour être désactivé afin de séparer le verrou de détection (522) de l'IDL, et
un transistor d'amplification ayant : une première borne couplée à l'IDL, une deuxième borne configurée pour recevoir un signal d'amplification, et une borne de grille configurée pour recevoir un signal de commande afin d'activer ou de désactiver le transistor d'amplification, et
dans lequel le transistor d'amplification est configuré pour être activé de sorte qu'un niveau de tension de l'IDL est associé à un niveau de tension du signal d'amplification.

5. Dispositif de mémoire (200), dans lequel le dispositif de mémoire (220) comprend :
un réseau de cellules de mémoire (210) comprenant des cellules de mémoire ;
le circuit tampon de page (220, 302, 400, 450, 802) selon l'une quelconque des
revendications 1 à 4 ; et
un circuit à verrouillage de données d'antémémoire, CDL, (230, 304) comprenant une pluralité d'antémémoires couplée à la pluralité de tampons de page (310) dans le circuit tampon de page (220, 302, 400, 450, 802) par l'intermédiaire de la pluralité de segment de bus de données (DBUS) (420),
dans lequel la pluralité de segments de DBUS (420) sont configurés pour être connectés ensemble par conductibilité en tant que bus de données (305) pour le transfert de données, et
dans lequel chaque segment de DBUS (420) de la pluralité de segments de DBUS (420) correspond au tampon de page (310) de la pluralité de tampons de page (310) et est configuré pour se séparer sur le plan de la conductibilité d'au moins un segment de DBUS adjacent (420) pour la détection de données dans le réseau de cellules de mémoire (210).

6. Dispositif de mémoire (220) selon la revendication 5, dans lequel chaque tampon de page de la pluralité de tampons de page comprend :
un premier transistor configuré pour être un transistor de connexion correspondant au tampon de page, et
un segment de DBUS, et
dans lequel le premier transistor a une première borne couplée au segment de DBUS du tampon de page, une deuxième borne couplée à un segment de DBUS adjacent d'un tampon de page adjacent, et une borne de grille configurée pour recevoir un signal de commande afin d'activer ou de désactiver le premier transistor.

7. Dispositif de mémoire (220) selon la revendication 6, dans lequel chaque tampon de page de la pluralité de tampons de page comprend en outre un deuxième transistor ayant : une première borne couplée à un ou plusieurs verrous dans le tampon de page par l'intermédiaire de l'au moins une ligne conductrice interne, une deuxième borne couplée au segment de DBUS, et une borne de grille couplée pour recevoir un deuxième signal de commande pour activer ou désactiver le deuxième transistor, et
dans lequel le dispositif de mémoire (220) est configuré pour :
activer la pluralité de transistors de connexion (316) pour connecter par conductibilité la pluralité de segments de DBUS (420) afin de former le bus de données, et
activer un deuxième transistor respectif d'un tampon de page spécifique de la pluralité de tampons de page et désactiver des deuxièmes transistors dans d'autres tampons de page de la pluralité de tampons de page, de sorte que des données verrouillées dans le tampon de page spécifique sont transférées du tampon de page spécifique à un cache correspondant dans le circuit CDL par l'intermédiaire du bus de données;
dans lequel le segment de DBUS est configuré pour se séparer sur le plan de la conductibilité du segment de DBUS adjacent et pour former un condensateur parasite (320, 527) avec au moins une ligne conductrice interne du tampon de page, et
dans lequel le deuxième transistor est configuré pour être activé afin de coupler le segment de DBUS à une tension d'alimentation pour le préchargement du condensateur parasite (320, 527) tandis que la pluralité de transistors de connexion (316) est désactivée pour séparer sur le plan de la conductibilité la pluralité de segments de DBUS (420).

8. Dispositif de mémoire (220) selon la revendication 5, dans lequel la pluralité de tampons de page comprend un premier tampon (460) et un deuxième tampon de page (470) disposés séquentiellement dans le circuit tampon de page (220, 302, 400, 450, 802), et
dans lequel un deuxième sous-segment du premier tampon de page (460) est couplé à un premier sous-segment du deuxième tampon de page (470) par un transistor de connexion correspondant parmi la pluralité de transistors de connexion (316).

9. Dispositif de mémoire (220) selon la revendication 5, dans lequel la pluralité de tampons de page comprend un premier tampon (460), un deuxième tampon (470) et un troisième tampon de page disposés dans l'ordre dans le circuit tampon de page (220, 302, 400, 450, 802), et
dans lequel des deuxièmes sous-segments du premier tampon de page (460) et le deuxième tampon de page (470) sont connectés par conductibilité, et des premiers sous-segments du deuxième tampon (470) et le troisième tampon de page sont couplés par l'intermédiaire d'un transistor de connexion correspondant parmi la pluralité de transistors de connexion (316).

10. Dispositif de mémoire (220) selon la revendication 5, dans lequel chaque tampon de page dans le circuit tampon de page (220, 302, 400, 450, 802) comprend une pluralité de verrous (532, 550), chacun couplé par conductibilité à l'IDL dans le tampon de page, et
dans lequel l'IDL dans le tampon de page est configurée pour former le condensateur parasite (320) avec un segment de DBUS correspondant pour le tampon de page.

11. Dispositif de mémoire (220) selon la revendication 10, dans lequel chaque tampon de page dans le circuit tampon de page (220, 302, 400, 450, 802) comprend :
un verrou de détection (522) couplé au réseau de cellules de mémoire, et
un transistor de verrouillage couplé entre le verrou de détection (522) et l'IDL et configuré pour être activé afin de connecter par conductibilité le verrou de détection (522) à l'IDL ou pour être désactivé afin de séparer le verrou de détection (522) de l'IDL.

12. Dispositif de mémoire (220) selon la revendication 10, dans lequel chaque tampon de page dans le circuit tampon de page (220, 302, 400, 450, 802) comprend un transistor d'amplification ayant : une première borne couplée à l'IDL, une deuxième borne configurée pour recevoir un signal d'amplification, et une borne de grille configurée pour recevoir un signal de commande afin d'activer ou de désactiver le transistor d'amplification, et
dans lequel le transistor d'amplification est configuré pour être activé de sorte qu'un niveau de tension de l'IDL est piloté en fonction d'un niveau de tension du signal d'amplification.

13. Circuit intégré (300), le circuit intégré (300) comprenant :
un premier circuit comprenant un circuit tampon de page (310) selon la revendication 1 comprenant une pluralité de tampons de page (PB0, PB1, ...) ; et
un deuxième circuit couplé au premier circuit par l'intermédiaire d'une pluralité de segments conducteurs (316-0, 316-1, 316-n), et comprenant un circuit à verrouillage de données d'antémémoire, CDL, (230, 304) comprenant une pluralité d'antémémoires ;
dans lequel la pluralité de segments conducteurs (316-0, 316-1, 316-n) sont
configurés pour être connectés ensemble par conductibilité en tant que bus conducteur (305) entre le premier circuit et le deuxième circuit, et
dans lequel chaque segment conducteur (316-0, 316-1, 316-n) de la pluralité de segments conducteurs (316-0, 316-1, 316-n) correspond à un circuit tampon de page (310) dans le premier circuit, et est configuré pour se séparer sur le plan de la conductibilité d'au moins un segment conducteur adjacent (316-0, 316-1, 316-n),
dans lequel le circuit intégré (300) est configuré pour transférer des données d'un tampon de page dans le circuit tampon de page (220, 302, 400, 450, 802) à une antémémoire correspondante dans le circuit CDL par l'intermédiaire du bus conducteur,
dans lequel chaque segment conducteur (316-0, 316-1, 316-n) de la pluralité de segments conducteurs (310) comprend :
un segment de DBUS (420) ayant un sous-segment de DBUS sans bruit de couplage (420a) et un sous-segment de DBUS à bruit de couplage (420b), et
un transistor de segment (414) couplé entre le sous-segment de DBUS sans bruit de couplage (420a) et le sous-segment de DBUS à bruit de couplage (420b), et
dans lequel le sous-segment de DBUS sans bruit de couplage (420a) est adjacent à une ligne métallique interne, IDL, afin de former un condensateur parasite, et le sous-segment de DBUS à bruit de couplage (420b) est adjacent à une ligne de bits,
dans lequel le transistor de segment (414) est configuré pour :
pendant une opération de transfert de données, être activé de sorte que le sous-segment de DBUS sans bruit de couplage (420a) et le sous-segment de DBUS à bruit de couplage (420b) sont connectés par conductibilité afin de former le segment de DBUS (420) pour le transfert de données, et
pendant un fonctionnement normal, être désactivé de sorte que le sous-segment de DBUS sans bruit de couplage (420a) est utilisé en tant que nœud capteur afin de former un condensateur parasite (320) pour la détection de données, tandis que le sous-segment de DBUS à bruit de couplage (420b) n'est pas utilisé.
